(19) **Europäisches Patentamt**
**European Patent Office**
**Office européen des brevets**

(11) **EP 4 407 859 A1**

(12) # EUROPEAN PATENT APPLICATION
published in accordance with Art. 153(4) EPC

(43) Date of publication:
**31.07.2024 Bulletin 2024/31**

(21) Application number: **22942103.7**

(22) Date of filing: **19.05.2022**

(51) International Patent Classification (IPC):
**H02N 2/18** (2006.01)

(52) Cooperative Patent Classification (CPC):
**H02N 2/18**

(86) International application number:
**PCT/CN2022/093975**

(87) International publication number:
**WO 2023/221063 (23.11.2023 Gazette 2023/47)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **Shenzhen Shokz Co., Ltd.
Shenzhen, Guangdong 518108 (CN)**

(72) Inventors:
• YUAN, Yongshuai
  **Shenzhen, Guangdong 518108 (CN)**
• HUANG, Yujia
  **Shenzhen, Guangdong 518108 (CN)**
• QI, Xin
  **Shenzhen, Guangdong 518108 (CN)**
• LIAO, Fengyun
  **Shenzhen, Guangdong 518108 (CN)**

(74) Representative: **Huang, Liwei
Cäcilienstraße 12
40597 Düsseldorf (DE)**

(54) **PIEZOELECTRIC TRANSDUCER, ACOUSTIC OUTPUT DEVICE AND SOUND TRANSMISSION DEVICE**

(57) Embodiments of the present disclosure provide a piezoelectric transducer. The piezoelectric transducer may include a piezoelectric layer and an electrode. The electrode may overlap at least one surface of the piezoelectric layer, and the electrode or the piezoelectric layer may include a plurality of concave structures recessed in a thickness direction of the electrode or the piezoelectric layer.

**400**

Piezoelectric layer  410

Electrode 420

**FIG. 4**

EP 4 407 859 A1

## Description

## TECHNICAL FIELD

The present disclosure relates to the field of piezoelectric technology, and in particular to piezoelectric transducers, acoustic output devices, and sound transmission devices.

## BACKGROUND

Currently, a piezoelectric transducer is commonly used in a Micro-ElectroMechanical Systems (MEMS) device (e.g., an accelerometer, a speaker, a microphone, an energy harvester, etc.) or a macro device to obtain great electrical signal output or mechanical physical quantity output by utilizing a piezoelectric effect or an inverse piezoelectric effect of the piezoelectric transducer. A conventional approach to achieving a great electrical signal output or a high mechanical physical quantity output using the piezoelectric device typically starts from a material design perspective, such as selecting a piezoelectric material with a relatively high piezoelectric coefficient to manufacture the piezoelectric transducer. Although the conventional approach effectively improves the electrical signal output or the mechanical physical quantity output of the piezoelectric transducer, it imposes high requirements on the piezoelectric material, potentially leading to high costs for the piezoelectric transducer.

Therefore, it is desirable to provide a piezoelectric transducer that can improve a stress distribution of the piezoelectric transducer through structural design, thereby enhancing the electrical signal output or the mechanical physical quantity output of the piezoelectric transducer.

## SUMMARY

Some embodiments of the present disclosure provide a piezoelectric transducer including a piezoelectric layer and an electrode. The electrode may overlap at least one surface of the piezoelectric layer, and the electrode or the piezoelectric layer may include a plurality of concave structures recessed in a thickness direction of the electrode or the piezoelectric layer.

In some embodiments, the piezoelectric layer may include a piezoelectric cantilever beam.

In some embodiments, the plurality of concave structures may include a plurality of grooves distributed along a length direction of the piezoelectric cantilever beam, and each of the plurality of grooves may extend in a width direction of the piezoelectric cantilever beam.

In some embodiments, the plurality of concave structures may include an array of holes distributed along a length direction and a width direction of the piezoelectric cantilever beam.

In some embodiments, the plurality of concave structures may be distributed in a region near a fixed end of the piezoelectric cantilever beam.

In some embodiments, a length of the region near the fixed end of the piezoelectric cantilever beam may be within a range of 1/3 to 1/4 of a length of the piezoelectric cantilever beam.

In some embodiments, the piezoelectric layer may include a piezoelectric plate or a piezoelectric film.

In some embodiments, the plurality of concave structures may include a plurality of grooves distributed along a first direction, where the first direction may extend from a center of the piezoelectric layer to an edge of the piezoelectric layer.

In some embodiments, the plurality of concave structures may include an array of holes distributed along a first direction and a second direction, where the first direction may extend from a center of the piezoelectric layer to an edge of the piezoelectric layer, and the second direction may be parallel to the edge of the piezoelectric layer.

In some embodiments, the plurality of concave structures may be distributed in a sub-region of the piezoelectric layer, the sub-region may be a region enclosed by midpoints of distances between a center and an edge of the piezoelectric layer.

In some embodiments, the plurality of concave structures may be distributed outside a sub-region of the piezoelectric layer and within the edge of the piezoelectric layer, where the sub-region may be a region enclosed by midpoints of distances between a center and an edge of the piezoelectric layer.

In some embodiments, an effective area of the electrode may be within a range of 30% to 70% of an area of the piezoelectric layer.

In some embodiments, a depth of at least one concave structure of the plurality of concave structures may be less than or equal to a thickness of the electrode.

In some embodiments, a spacing between two adjacent concave structures of the plurality of concave structures may be less than three times a depth of one concave structure of the two adjacent concave structures.

In some embodiments, a width of at least one concave structure of the plurality of concave structures may be equal to 1 to 2 times a depth of one concave structure of the plurality of concave structures.

In some embodiments, a cross-sectional shape of at least one concave structure of the plurality of concave structures may include at least one of a rectangular shape, an arc shape, a triangular shape, a pentagonal shape, or a hexagonal shape.

In some embodiments, at least one concave structure of the plurality of concave structures may be arc-shaped along a length direction of the at least one concave structure.

In some embodiments, a ratio of a thickness of the electrode to a thickness of the piezoelectric layer may be greater than or equal to 1:10 and less than or equal to 1:4.

In some embodiments, the plurality of concave structures may be interconnected through a conductive component.

In some embodiments, the conductive component may include a metal connecting part integrally formed with the plurality of concave structures or a metal layer covering the plurality of concave structures.

In some embodiments, piezoelectric transducer may further include a polymer material layer covering the plurality of concave structures.

In some embodiments, a Young's modulus of the polymer material layer may be less than a Young's modulus of the piezoelectric layer or a Young's modulus of the electrode.

In some embodiments, a thickness of the polymer material layer may be equal to 1 to 10 times a thickness of the piezoelectric layer.

In some embodiments, the plurality of concave structures may be distributed on the electrode and the piezoelectric layer, and recessions of the plurality of concave structures may extend from the electrode to the piezoelectric layer.

Some embodiments of the present disclosure provide an acoustic output device which includes the piezoelectric transducer described in the present disclosure.

Some embodiments of the present disclosure provide a sound transmission device which includes the piezoelectric transducer described in the present disclosure.

**BRIEF DESCRIPTION OF THE DRAWINGS**

The present disclosure is further illustrated by way of exemplary embodiments, which are described in detail through the accompanying drawings. These embodiments are not limiting, and in these embodiments, the same numbering indicates the same structure, where:

FIG. 1 is an exemplary structural diagram of a stress distribution on a cross-section of a piezoelectric transducer according to some embodiments of the present disclosure;

FIG. 2 is a schematic diagram of a stress distribution in a stress field at a tip of a single crack on a piezoelectric transducer according to some embodiments of the present disclosure;

FIG. 3 is a schematic diagram of a stress distribution in a stress field at tips of two cracks on a piezoelectric transducer according to some embodiments of the present disclosure;

FIG. 4 is an exemplary frame diagram of a piezoelectric transducer according to some embodiments of the present disclosure;

FIG. 5 is a locally enlarged view of a piezoelectric transducer according to some embodiments of the present disclosure;

FIG. 6A is an exemplary structural diagram of a piezoelectric cantilever beam according to some embodiments of the present disclosure;

FIG. 6B is a top view of a piezoelectric cantilever beam according to some embodiments of the present disclosure;

FIG. 6C is a main view of a piezoelectric cantilever beam according to some embodiments of the present disclosure;

FIG. 6D is a locally enlarged view of a piezoelectric cantilever beam according to some embodiments of the present disclosure;

FIG. 7A is an exemplary structural diagram of a piezoelectric film according to some embodiments of the present disclosure;

FIG. 7B is a top view of a piezoelectric film according to some embodiments of the present disclosure;

FIG. 7C is a main view of a piezoelectric film according to some embodiments of the present disclosure; and

FIG. 8 is frequency response curves of piezoelectric transducers according to some embodiments of the present disclosure.

**DETAILED DESCRIPTION**

In order to more clearly illustrate the technical solutions of the embodiments of the present disclosure, the accompanying drawings for the description of the embodiments are described below. Obviously, the accompanying drawings in the following description are only some examples or embodiments of the present disclosure, and a person of ordinary skill in the art can apply the present disclosure to other similar scenarios in accordance with these accompanying drawings without creative labor. Unless obviously obtained from the context or the context illustrates otherwise, the same numeral in the drawings refers to the same structure or operation.

It should be understood that the terms "system," "device," "unit," and/or "module" are used herein as a way to distinguish between different components, elements, parts, sections, or assemblies at different levels. However, if other words may achieve the same purpose, the terms may be replaced with alternative expressions.

As indicated in the present disclosure and in the claims, unless the context clearly suggests an exception, the words "one," "a," "an," and/or "the" do not refer specifically to the singular but may also include the plural. In general, the terms "include" and "comprise" suggest only the inclusion of clearly identified steps and elements, which do not constitute an exclusive list, and the method or device may also include other steps or elements.

The present disclosure uses flowcharts to illustrate the operations performed by the system according to some embodiments of the present disclosure. It should be understood that the operations described herein are not necessarily executed in a specific order. Instead, they may be executed in reverse order or simultaneously. Additionally, other operations may be added to these processes or certain operations may be removed.

Some embodiments of the present disclosure provide a piezoelectric transducer. In some embodiments, the piezoelectric transducer may include a piezoelectric layer and an electrode. The electrode may overlap at least one surface of the piezoelectric layer. During a vibration process, the piezoelectric transducer undergoes bending deformation, and a high-stress region during the bending deformation is typically distributed in the electrode. A stress in the piezoelectric layer, where high stress is needed, is much lower than a stress in the electrode. From the perspective of stress utilization, this design may result in wasteful stress within the piezoelectric transducer. Therefore, it is possible to design a structure of the piezoelectric transducer to improve a stress distribution within the transducer, thereby increasing the stress in the piezoelectric layer and subsequently enhancing an electrical signal output or a mechanical physical quantity output of the piezoelectric transducer. In some embodiments, a plurality of concave structures recessed in a thickness direction of the electrode or the piezoelectric layer may be provided on the electrode or the piezoelectric layer. A shape change at end positions of the plurality of concave structures is utilized to increase the stress at the end positions and their nearby positions, thereby increasing the stress in the piezoelectric layer.

In some embodiments, the piezoelectric transducer may be applied to an acoustic output device, such as a speaker, etc. In some embodiments, the piezoelectric transducer may be applied to a sound transmission device, such as a microphone, a hearing aid, etc. In some embodiments, the piezoelectric transducer may be applied to MEMS or a macro device, such as an accelerometer, an energy harvester, etc.

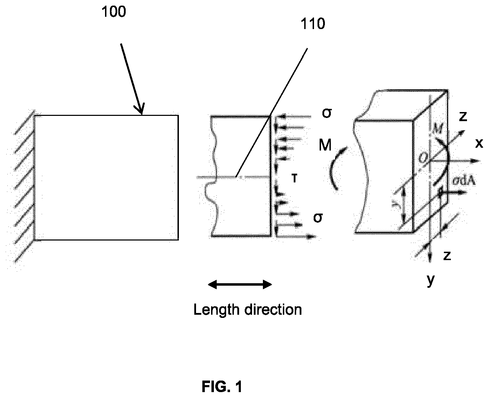

Taking the example of a structure of a piezoelectric cantilever beam as the structure of the piezoelectric transducer, the stress distribution in the piezoelectric transducer during bending deformation is described. FIG. 1 is an exemplary structural diagram of a stress distribution on a cross-section of a piezoelectric transducer according to some embodiments of the present disclosure. Referring to FIG. 1, according to material mechanics, a distribution of bending tensile stress on the cross-section of a piezoelectric cantilever beam 100 during bending deformation may be represented by formula (1):

$$\sigma_x = \frac{My}{I_y} \quad , \quad (1)$$

where $\sigma_x$ denotes the bending tensile stress on the cross-section of the piezoelectric cantilever beam 100, M denotes a bending moment of the piezoelectric cantilever beam 100, y denotes a distance from a point on the cross-section of the piezoelectric cantilever beam 100 to a central axis 110 of the piezoelectric cantilever beam 100, and $I_y$ denotes a moment of inertia of the cross-section of the piezoelectric cantilever beam 100. In some embodiments, as shown in FIG. 1, the central axis 110 of the piezoelectric cantilever beam 100 refers to the central axis along a longitudinal axis direction of the piezoelectric cantilever beam 100. According to formula (1), when other parameters are fixed, the bending tensile stress $\sigma_x$ on the cross-section of the piezoelectric cantilever beam 100 is directly proportional to the distance y from a point on the cross-section to the central axis 110 of the piezoelectric cantilever beam 100. The larger the distance from a point on the cross-section to the central axis 110 of the piezoelectric cantilever beam 100, the greater the bending tensile stress at the point; the smaller the distance from a point on the cross-section to the central axis 110 of the piezoelectric cantilever beam 100, the smaller the bending tensile stress at the point. Thus, utilizing formula (1), it is possible to determine the tensile stress at different positions on the cross-section of the piezoelectric cantilever beam 100, thereby obtaining the distribution of bending tensile stress on the cross-section of the piezoelectric cantilever beam 100.

In some embodiments, the piezoelectric transducer may include a piezoelectric layer and an electrode. In some embodiments, the electrode may be located on a surface of the piezoelectric layer, causing a distance from the electrode to the central axis 110 of the piezoelectric cantilever beam 100 to be greater than a distance from the piezoelectric layer to the central axis 110 of the piezoelectric cantilever beam 100. Combining FIG. 1 and formula (1), it may be observed that when the piezoelectric transducer undergoes bending deformation, a distance from a point in the electrode on the cross-section of the piezoelectric cantilever beam 100 to the central axis 110 is greater than a distance from a point in the piezoelectric layer to the central axis 110 of the piezoelectric cantilever beam 100. Consequently, a stress in the electrode is greater than a stress in the piezoelectric layer. It may also be understood that the high stress in the piezoelectric transducer is distributed within the electrode.

In some embodiments, stress at a position (e.g., a notch, a hole, a groove, and a rigidly constrained position) where a geometric shape or a constraint of a structure of an object undergoes an abrupt change may experience localized increases. In other words, stress concentration occurs at the position where the geometric shape or the constraint of the structure of the object undergoes the abrupt change. The more abrupt the change in the geometric shape of the structure of the object, the more severe the increase in stress at the position with the abrupt change. For example, a crack may be a structure with a relatively abrupt change in geometry, and therefore, a tip of the crack may exhibit significant stress concentration.

In some embodiments, according to fracture mechanics, a stress field at the tip of the crack may be represented by formula (2):

$$\begin{cases} \sigma_x = \dfrac{K_I}{\sqrt{2\pi r}}\cos\dfrac{\theta}{2}\left(1-\sin\dfrac{\theta}{2}\sin\dfrac{3\theta}{2}\right) \\ \sigma_x = \dfrac{K_I}{\sqrt{2\pi r}}\cos\dfrac{\theta}{2}\left(1+\sin\dfrac{\theta}{2}\sin\dfrac{3\theta}{2}\right), \quad (2) \\ \tau_{xy} = \dfrac{K_I}{\sqrt{2\pi r}}\sin\dfrac{\theta}{2}\cos\dfrac{\theta}{2}\cos\dfrac{3\theta}{2} \end{cases}$$

where r and θ denote polar coordinates of the tip of the crack, and denotes a stress intensity factor. The stress intensity factor may be used to describe an intensity of the stress field at the tip of the crack. The stress intensity factor may be expressed as $K_I = Y\sigma\sqrt{\pi a}$, where Y denotes a shape factor, a denotes a nominal stress, and a denotes a length of the crack. In some embodiments, the shape factor may be determined by the geometric shape of the crack. For example, a crack with a right-angle shape may have a large shape factor. The nominal stress may depend on an external load and a material distribution. As per formula (2), the intensity of the stress field at the tip of the crack is influenced by parameters such as the geometric shape of the crack, the nominal stress exerted externally, and the length of the crack. In some embodiments, the length of the crack may be the primary parameter for adjusting the intensity of the stress field at the tip of the crack.

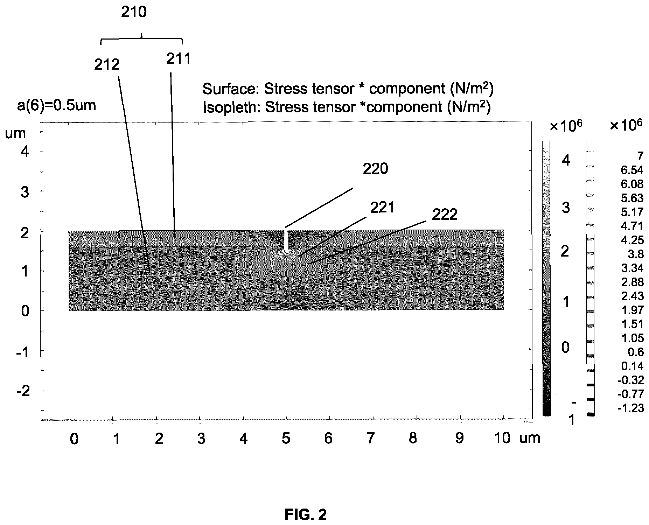

FIG. 2 is a schematic diagram of a stress distribution in a stress field at a tip of a single crack on a piezoelectric transducer 210 according to some embodiments of the present disclosure. For illustrative purposes, an upper layer of the piezoelectric transducer 210 in FIG. 2 is an electrode 211, and a lower layer of the piezoelectric transducer 210 is a piezoelectric layer 212, with the electrode 211 attached to a surface of the piezoelectric layer 212. In some embodiments, a crack 220 may extend from the electrode 211 to the piezoelectric layer 212. Different shades in a piezoelectric cantilever beam in FIG. 2 represent varying stress intensity at corresponding positions. Darker shades indicate lower stress intensity at the corresponding position, while lighter shades indicate higher stress intensity. Referring to FIG. 2, when comparing the electrode 211 and the piezoelectric layer 212, it may be observed that in most regions of the electrode 211, the shade is lighter than in most regions of the piezoelectric layer 212, indicating that the stress intensity in most regions of the electrode 211 is higher than the stress intensity in most regions of the piezoelectric layer 212. Near the crack 220, the closer a position is to the tip of the crack 220, the lighter the shade, the higher the stress intensity is at the position.

The tip of the crack 220 refers to an end where the crack 220 extends into the piezoelectric layer 212. A first contour line 221 in FIG. 2 is closer to the tip of the crack 220 than a second contour line 222, with positions inside the first contour line 221 having lighter shades and higher stress intensity than positions inside the second contour line 222.

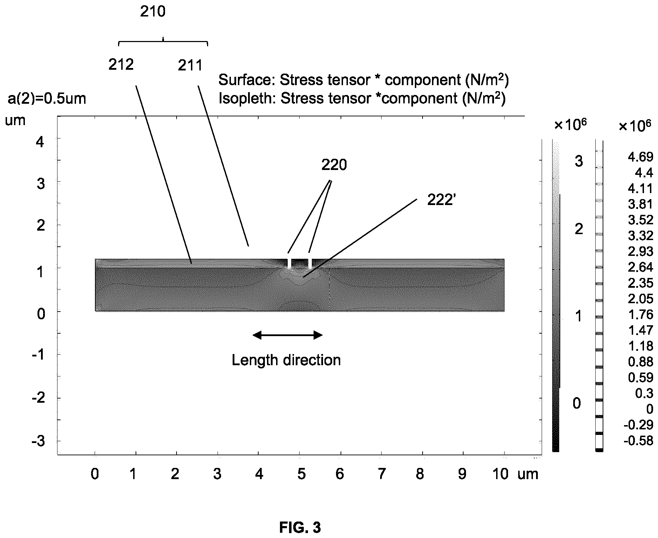

In some embodiments, to enhance the stress intensity in the piezoelectric layer of the piezoelectric transducer to a great extent, a plurality of cracks may be provided in the piezoelectric transducer. By increasing the stress intensity near each tip of the plurality of cracks, the stress intensity in the piezoelectric layer can be enhanced over a larger range. FIG. 3 is a schematic diagram of a stress distribution in a stress field at tips of two cracks on a piezoelectric transducer according to some embodiments of the present disclosure. As shown in FIG. 3, when a piezoelectric cantilever beam-type transducer 210 includes two cracks 220, the stress intensity near the tip of each crack 220 is increased. This results in a large increase in stress intensity along a length direction (i.e., a major axis direction) of the piezoelectric layer 212 in the piezoelectric cantilever beam-type transducer 210. Furthermore, comparing FIGs. 3 and 2, a coverage range of a stress band between a second contour line 222' and its surrounding contour lines is increased, which helps to achieve a more uniform distribution of the enhanced stress intensity throughout the piezoelectric cantilever beam-type transducer 210. In some embodiments, to further enhance the stress intensity in the piezoelectric layer of the transducer (e.g., the electrode, the piezoelectric layer), a plurality of structures with abrupt changes in geometric shapes may be introduced in the transducer. By reasonably adjusting structural parameters (e.g., a geometric shape, a dimension, a positional distribution) of the plurality of structures, the stress distribution in the piezoelectric transducer can be improved, leading to increased stress in the piezoelectric layer. In some embodiments, cracks may be regarded as a type of concave structure. It should be understood that the crack structures shown in FIGs. 2 and 3 are just examples of the concave structure. Structures altering the stress intensity in the piezoelectric layer may be any concave structure, such as a groove, a hole structure, a crack, etc., that recesses inward in a thickness direction of the piezoelectric layer. The principles remain the same, and the details of each structure need not be discussed individually in the present disclosure.

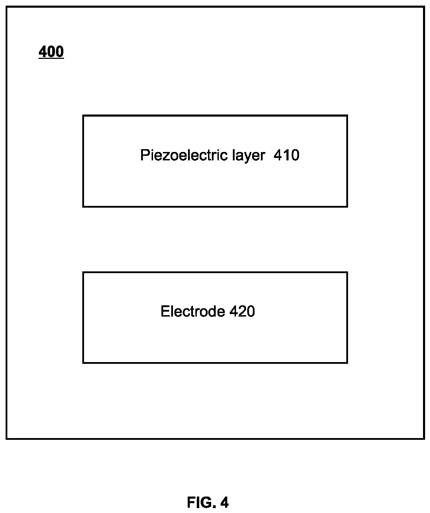

FIG. 4 is an exemplary frame diagram of a piezoelectric transducer 400 according to some embodiments of the present disclosure.

The piezoelectric transducer 400 refers to a component with a piezoelectric effect or an inverse piezoelectric effect. In some embodiments, the piezoelectric transducer 400 may be configured to generate a vibration based on an electrical signal. For example, when an alternating electrical signal is applied to the piezoelectric transducer 400, the piezoelectric transducer 400 may undergo reciprocating deformation and generate vibrations under an influence of the alternating electrical signal. In some embodiments, the piezoelectric transducer 400 may also undergo deformation under an influence of an external vibration signal and generate an electrical signal based on the deformation.

In some embodiments, the piezoelectric transducer 400 may include a piezoelectric layer 410 and an electrode 420. The electrode 420 overlaps at least one surface of the piezoelectric layer 410. In some embodiments, the piezoelectric layer 410 may be a structure capable of generating a vibration under an action of a driving voltage, with the electrode 420 providing the driving voltage to the piezoelectric layer 410. In some embodiments, the piezoelectric layer 410 may also be a structure that undergoes deformation under an external force (e.g., a vibration of a vibrating component) and generates an electrical signal based on the deformation, with the electrode 420 used for transmitting the electrical signal. In some embodiments, the piezoelectric layer 410 may be a single-layer structure. In some embodiments, the piezoelectric layer 410 may be a multi-layer structure. For example, the piezoelectric layer 410 may be a bilayer structure, including a first piezoelectric layer and a second piezoelectric layer. The first piezoelectric layer and the second piezoelectric layer are arranged along a thickness direction of the piezoelectric transducer 400, and they are connected by the electrode 420. Here, the thickness direction refers to a stacking direction of the piezoelectric transducer 400. Along the stacking direction of the piezoelectric transducer 400, the electrode 420 and two or more layers of the piezoelectric layer 410 are alternately stacked to form the piezoelectric transducer 400.

In some embodiments, the piezoelectric layer 410 may be a piezoelectric polymer film obtained through semiconductor deposition processes (e.g., magnetron sputtering, Metal-Organic Chemical Vapor Deposition (MOCVD)). In some embodiments, a material of the piezoelectric layer 410 may include a piezoelectric crystal material and a piezoelectric ceramic material. A piezoelectric crystal refers to a piezoelectric single crystal. In some embodiments, the piezoelectric crystal material may include crystals such as quartz, sphalerite, boracite, tourmaline, cinnabar, GaAs, barium titanate, potassium dihydrogen phosphate (Rochelle salt), etc., or any combination thereof. A piezoelectric ceramic material refers to a polycrystalline piezoelectric material obtained through a solid-phase reaction and sintering of different material particles. In some embodiments, the piezoelectric ceramic material may include barium titanate (BT), lead zirconate titanate (PZT), lead barium lithium niobate (PBLN), modified lead titanate (PT), aluminum nitride (AIN), zinc oxide (ZnO), etc., or any combination thereof. In some embodiments, the material of the piezoelectric layer 410 may also be a piezoelectric polymer material, such as polyvinylidene fluoride (PVDF), etc.

In some embodiments, the piezoelectric layer 410 may include a piezoelectric cantilever beam. The piezoelectric cantilever beam may include a fixed region (e.g., a fixed end) and a vibration output region (e.g., a vibration output end). The fixed region is used to fix a portion of the piezoelectric transducer 400 and suppress vibration within the portion, allowing most of the vibration of the piezoelectric transducer 400 to be output from the vibration output region. In some embodiments, one end of the piezoelectric cantilever beam along a long axis direction may be the vibration output region, and the other end corresponding to the long axis direction of the vibration output region may be the fixed region.

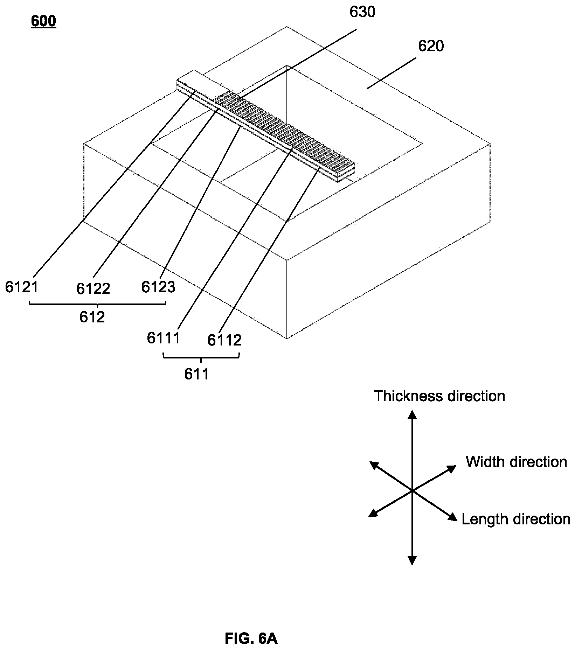

In some embodiments, when the piezoelectric layer 410 includes the piezoelectric cantilever beam, a geometric structure of a concave structure may include a groove or an array of holes. In some embodiments, when the piezoelectric transducer 400 includes the piezoelectric cantilever beam, a plurality of concave structures may include a plurality of grooves distributed along a length direction of the piezoelectric cantilever beam. Each groove of the plurality of grooves extends along a width direction of the piezoelectric cantilever beam. In some embodiments, when the piezoelectric transducer 400 includes a piezoelectric cantilever beam, the plurality of concave structures may also include an array of holes distributed along both the length and width directions of the piezoelectric cantilever beam. The array of holes refers to a series of small holes (e.g., circular holes, square holes, etc.) forming the array of holes. In some embodiments, the groove may be considered as a limit structure of the array of holes. More descriptions of the concave structure when the piezoelectric transducer 400 includes the piezoelectric cantilever beam may be found in FIGs. 6A-6D and the related descriptions thereof.

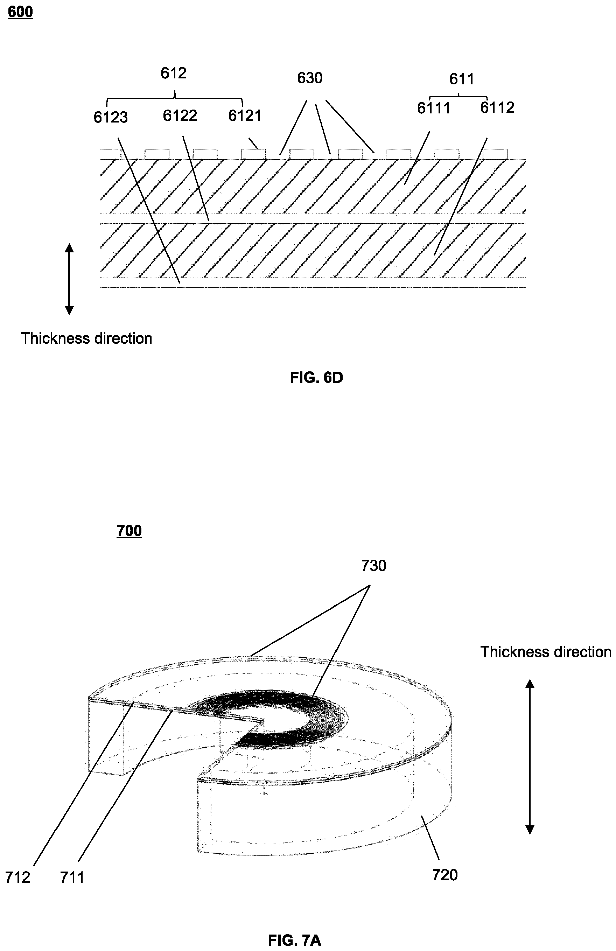

In some embodiments, the piezoelectric layer 410 may include a piezoelectric plate or a piezoelectric film. The piezoelectric plate may be a plate-like structure, and the piezoelectric film may be a film-like structure. The electrode 420 is attached to one or more surfaces of the plate-like structure or the film-like structure perpendicular to the thickness direction of the piezoelectric transducer 400. In some embodiments, when the piezoelectric layer 410 includes the piezoelectric plate or the piezoelectric film, the plurality of concave structures may include a plurality of grooves distributed along a first direction. The first direction may be a direction from a center of the piezoelectric transducer 400 to an edge of the piezoelectric transducer 400. The edge of the piezoelectric transducer 400 may be a circumferential edge of the piezoelectric transducer 400. For example, when the piezoelectric transducer 400 is a circular plate-like structure, the first direction may be a radial direction from a center of the circular plate-like structure to a circumference of the circular plate-like structure. The edge of the piezoelectric transducer 400 may be a circumferential edge of the circular plate-like structure. In some embodiments, when the piezoelectric transducer 400 includes the piezoelectric plate or the piezoelectric film, the plurality of concave structures may include an array of holes distributed along the first direction and a second direction. In some embodiments, the first direction may be a direction from the center of the plate-like structure or the film-like structure to the edge of the plate-like structure or the film-like structure, and the second direction is parallel to the edge of the piezoelectric transducer 400. In some embodiments, the second direction may be a circumferential direction of the plate-like structure or the film-like structure. For example, when the piezoelectric layer 410 is a circular plate-like structure, the first direction may be a radial direction from the center of the circular plate-like structure to the circumference of the circular plate-like structure, and the second direction may be a circumferential direction of the circular plate-like structure. In some embodiments, a structural shape of the piezoelectric plate or the piezoelectric plate film may include but is not limited to a regular geometric shape such as a circle, a square, a pentagon, etc., and/or an irregular geometric shape. More description of the concave structure when the piezoelectric layer 410 includes the piezoelectric plate or the piezoelectric film may be found in FIGs. 7A-7C and the related descriptions thereof.

In some embodiments, the piezoelectric transducer 400 may include one or more electrodes 420. For example, the piezoelectric transducer 400 may include one electrode that overlaps any surface of the piezoelectric layer 410 perpendicular to the thickness direction of the piezoelectric transducer 400. In some embodiments, the piezoelectric transducer 400 may include a plurality of electrodes. For example, the piezoelectric transducer 400 may have two electrodes, namely a first electrode and a second electrode. The first electrode and the second electrode are respectively placed over two surfaces of the piezoelectric layer 410 in the thickness direction of the piezoelectric transducer 400. In this case, the piezoelectric layer 410 is positioned between the first electrode and the second electrode. In some embodiments, when the piezoelectric transducer 400 includes a plurality of piezoelectric layers 410, a plurality of electrodes 420 may correspond to the plurality of piezoelectric layers 410, and the plurality of piezoelectric layers 410 are connected via the plurality of electrodes 420. Along the thickness direction of the piezoelectric transducer 400, the plurality of electrodes 420 and the plurality of piezoelectric layers 410 are alternately arranged. In some embodiments, the one or more electrodes 420 may provide a driving voltage to the piezoelectric layer 410 to induce vibration. In some embodiments, the one or more electrode 420 may also collect an electrical signal generated when the piezoelectric layer 410 deforms.

In some embodiments, based on the descriptions of FIGs. 1-3, to improve the stress distribution in the piezoelectric transducer 400 and enhance the stress intensity in the piezoelectric layer 410, a plurality of concave structures that are recessed in the thickness direction of the electrode 420 or the piezoelectric layer 410 may be provided on the piezoelectric transducer 400 (e.g., the electrode 420, the piezoelectric layer 410). In some embodiments, a geometric shape of end portions of the plurality of concave structures where the concave structures recess inward in the thickness direction of the piezoelectric layer 410 may have an abrupt change, causing stress concentration in the end portions and nearby positions, thereby increasing the stress in the piezoelectric layer 410 and subsequently enhancing an output of the piezoelectric transducer 400. In some embodiments, the plurality of concave structures may include grooves, hole structures, cracks, or any combination thereof.

In some embodiments, the plurality of concave structures may be distributed within the electrode 420. For example, along the thickness direction of the piezoelectric transducer 400, one end of the plurality of concave structures extends from an end surface (referred to as a non-adhesive end surface) of the electrode 420, which is far from contact with the piezoelectric layer 410, toward another end surface (referred to as an adhesive end surface) of the electrode 420, which is in contact with the piezoelectric layer 410. The plurality of concave structures are distributed throughout the electrode 420. In some embodiments, a depth of the concave structure may be less than a thickness of the electrode 420. The depth of the concave structure refers to a dimension of the concave structure along the thickness direction of the piezoelectric transducer 400. In some embodiments, when the plurality of concave structures are distributed within the electrode 420, the depth of the concave structure may also be equal to the thickness of the electrode 420. For example, two ends of the concave structure are aligned with the non-adhesive end surface and the adhesive end surface of the electrode 420, respectively.

In some embodiments, the plurality of concave structures may also be arranged within the electrode 420 and the piezoelectric layer 410. For example, along the thickness direction of the piezoelectric transducer 400, one end of the concave structure extends from the non-adhesive end surface of the electrode 420 towards the piezoelectric layer 410, and the other end of the concave structure extends into the piezoelectric layer 410. When the plurality of concave structures are arranged within the electrode 420 and the piezoelectric layer 410, the depth of the concave structure along the thickness direction of the piezoelectric transducer 400 may be greater than the thickness of the electrode 420. In some embodiments, the plurality of concave structures may be arranged within the piezoelectric layer 410, and along the thickness direction of the piezoelectric transducer 400, one end of the concave structure extends from the adhesive end surface of the electrode 420 towards the piezoelectric layer 410. The plurality of concave structures are distributed throughout the piezoelectric layer 410.

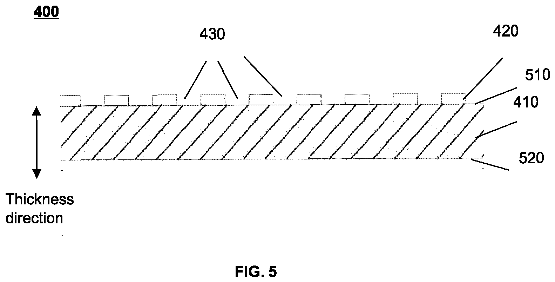

FIG. 5 is a locally enlarged view of a piezoelectric transducer according to some embodiments of the present disclosure. As shown in FIG. 5, the electrode 420 may be placed over an upper surface 510 of the piezoelectric layer 410 in a thickness direction. The electrode 420 may include a plurality of concave structures 430 (e.g., grooves) recessed in a thickness direction of the piezoelectric transducer 400 towards the electrode 420 or the piezoelectric layer 410. It should be understood that FIG. 5 is for illustration purposes, and the electrode 420 may also be placed over a lower surface 520 of the piezoelectric layer 410 in the thickness direction. The plurality of concave structures 430 may be arranged on the electrode 420 located on the lower surface of the piezoelectric layer 410. In some embodiments, the plurality of concave structures 430 may be arranged on the electrode 420 and the piezoelectric layer 410. For example, recesses of the plurality of concave structures 430 may extend from the electrode 420 into the piezoelectric layer 410.

In some embodiments, when the plurality of concave structures are distributed within the electrode 420 and the depth of the concave structures equals the thickness of the electrode 420, the electrode 420 may be segmented into a plurality of isolated electrodes that are not connected to each other. Two adjacent electrodes of the plurality of isolated electrodes are separated by one concave structure of the plurality of concave structures. Isolated electrodes that are not connected may not be used to transmit an electrical signal. Therefore, to ensure that the electrode 420 conducts and transmits the electrical signal, the plurality of isolated electrodes may be connected. In some embodiments, the isolated electrodes between the plurality of concave structures may be electrically connected by a conductive component. In some embodiments, two adjacent isolated electrodes in the electrode 420 with the plurality of concave structures may be electrically connected by a metal wire, which may be integrally formed with the plurality of concave structures, achieving an overall connection of the electrode 420. In some embodiments, the metal wire may be placed over a plurality of isolated electrodes or the piezoelectric layer 410 through deposition, printing, etching, etc., to connect the plurality of isolated electrodes. In some embodiments, two adjacent isolated electrodes in the electrode 420 with the plurality of concave structures may be electrically connected by a metal layer, achieving an overall connection of the electrode 420. For example, after a plurality of isolated electrodes are adhered to a surface (i.e., an adhesive end surface) of the piezoelectric layer 410, a thin metal layer may be deposited on a surface of the electrode 420. The metal layer covers the plurality of concave structures and surfaces of the plurality of isolated electrodes, establishing electrical connections between the plurality of isolated electrodes through the metal layer to achieve interconnection of the electrode 420. In some embodiments, the metal layer may have strong electrical conductivity. In some embodiments, the metal layer may also have a certain level of toughness and/or ductility, ensuring that the metal layer has a certain strength and avoiding bending or damage at the concave structures. In some embodiments, a thickness of the metal layer may be set relatively small to reduce an impact of stress concentration on the electrode 420 and the piezoelectric layer 410. Merely by way of example, a material of the metal layer may be titanium alloy, titanium platinum, etc.

In some embodiments, by providing the concave structure 430 in the piezoelectric layer 410, the stress in the piezoelectric layer 410 can be enhanced. However, the concave structure may increase a risk of structural fracture in the piezoelectric transducer 400. To reduce the risk of structural fracture in the piezoelectric transducer 400 and ensure a reliability of the piezoelectric transducer 400, one or more layers of polymer material may be deposited on a surface of a stress-concentrated structure (e.g., the electrode 420 or the piezoelectric layer 410). In some embodiments, the piezoelectric transducer 400 may include a polymer material layer covering the plurality of concave structures. In some embodiments, a Young's modulus of the polymer material layer may be less than a Young's modulus of the piezoelectric layer 410 or a Young's modulus of the electrode 420. In some embodiments, the polymer material layer may also cover the entire electrode 420. In some embodiments, along the thickness direction of the piezoelectric transducer 400, a thickness of the polymer material layer may be in a range of 0.1 to 50 times a thickness of the piezoelectric layer 410. In some embodiments, along the thickness direction of the piezoelectric transducer 400, the thickness of the polymer material layer may be in a range of 1 to 10 times the thickness of the piezoelectric layer 410. In some embodiments, a material of the polymer material layer may include, but is not limited to, polyimide (PI), polydimethylsiloxane (PDMS), and other process-compatible materials.

In some embodiments, the piezoelectric transducer 400 may also include a matrix structure. The matrix structure may be a carrier used to support components (e.g., piezoelectric layer 410, electrode 420) of the piezoelectric transducer 400. In some embodiments, a material of the matrix structure may include: metal (such as copper foil, steel, etc.), phenolic resin, cross-linked polystyrene, or a combination thereof. In some embodiments, a shape of the matrix structure may be determined based on a shape of the piezoelectric layer. For example, if the piezoelectric layer is a piezoelectric cantilever beam, the matrix structure may be configured as elongated correspondingly. As another example, if the piezoelectric layer is a piezoelectric film or a piezoelectric plate, the matrix structure may be configured as plate-shaped or sheet-shaped correspondingly. In some embodiments, the matrix structure may be a regular or irregular three-dimensional structure with an internal hollow part, such as a hollow frame structure, including but not limited to a rectangular frame, a circular frame, a regular polygon frame, and any irregular shapes. The piezoelectric layer 410 and the electrode 420 may be located in the hollow part of the matrix structure or at least partially suspended above the hollow part of the matrix structure. In some embodiments, at least a portion of a structure of the piezoelectric layer 410 and the electrode 420 may be fixed on an upper surface or a lower surface of the matrix structure along the thickness direction of the piezoelectric transducer 400, or fixed on a sidewall of the matrix structure. For example, when the piezoelectric layer 410 is the piezoelectric cantilever beam, one end of the piezoelectric cantilever beam may be connected to the surface (e.g., the upper surface or the lower surface) of the matrix structure or to the sidewall of the hollow part where the matrix structure is located, while the other end of the piezoelectric cantilever beam is not connected or in contact with the matrix structure, allowing the other end of the piezoelectric cantilever beam to be suspended above the hollow part of the matrix structure. As another example, when the piezoelectric layer 410 is the piezoelectric plate or the piezoelectric film, an edge of the piezoelectric plate or an edge of the piezoelectric film may be fixedly connected to the matrix structure.

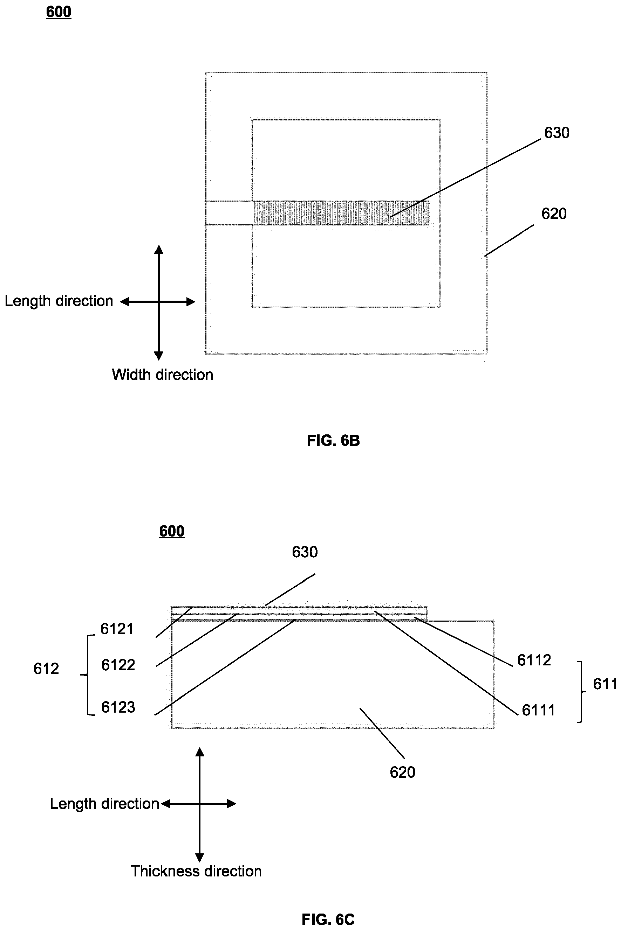

In some embodiments, the piezoelectric transducer 400 may include the piezoelectric cantilever beam. FIG. 6A is an exemplary structural diagram of a piezoelectric cantilever beam according to some embodiments of the present disclosure. FIG. 6B is a top view of a piezoelectric cantilever beam according to some embodiments of the present disclosure. FIG. 6C is a main view of a piezoelectric cantilever beam according to some embodiments of the present disclosure. FIG. 6D is a locally enlarged view of a piezoelectric cantilever beam according to some embodiments of the present disclosure.

In some embodiments, a piezoelectric cantilever beam 600 may include a piezoelectric layer 611 and an electrode 612. The electrode 612 is attached to at least one surface of the piezoelectric layer 611. In some embodiments, the electrode 612 may provide a driving voltage to the piezoelectric layer 611 to induce a vibration in the piezoelectric layer 611 under an action of the driving voltage. In some embodiments, the electrode 612 may conduct an electrical signal generated by deformation of the piezoelectric layer 611. The piezoelectric layer 611 may include one or more piezoelectric layers, arranged along a thickness direction of the piezoelectric cantilever beam 600. The electrode 612 may include one or more electrodes, arranged along the thickness direction of the piezoelectric cantilever beam 600. The one or more piezoelectric layers and the one or more electrodes are alternately arranged along the thickness direction of the piezoelectric cantilever beam 600.

In some embodiments, as shown in FIGs. 6A-6D, the piezoelectric layer 611 may include a first piezoelectric layer 6111 and a second piezoelectric layer 6112, arranged along the thickness direction of the piezoelectric cantilever beam 600. The electrode 612 may include a first electrode 6121, a second electrode 6122, and a third electrode 6123, arranged along the thickness direction of the piezoelectric cantilever beam 600. Along the thickness direction of the piezoelectric cantilever beam 600, two piezoelectric layers and three electrode layers are alternately arranged. In other words, along the thickness direction of the piezoelectric cantilever beam 600, the first electrode 6121, the first piezoelectric layer 6111, the second electrode 6122, the second piezoelectric layer 6112, and the third electrode 6123 are sequentially arranged. In some embodiments, the electrode 612 may not include the third electrode 6123, and at a position of the third electrode 6123, an elastic layer may be provided as part of a matrix structure 620. It should be understood that the count of piezoelectric layer 611 and the electrode 612 is only illustrative and does not limit the scope of the present disclosure. In other embodiments, the count of the piezoelectric layer 611 and the electrode 612 may be set based on requirements or application scenarios of the piezoelectric cantilever beam 600.

In some embodiments, as shown in FIGs. 6A-6D, at least a portion of a structure of the piezoelectric cantilever beam 600 may be fixed on an upper surface (as shown in FIG. 6A) or a lower surface of the matrix structure 620, perpendicular to the thickness direction of the piezoelectric cantilever beam 600. Alternatively, the at least a portion of the structure of the piezoelectric cantilever beam 600 may be fixed on a sidewall of the matrix structure 620. In some embodiments, the piezoelectric cantilever beam 600 may include a fixed region (e.g., a fixed end) and a vibration output region (e.g., a vibration output end). The fixed region refers to the region where the piezoelectric cantilever beam 600 is connected to the matrix structure 620. The fixed region is used to fix a portion of the piezoelectric cantilever beam 600 and suppress the vibration of the piezoelectric cantilever beam 600 in the portion, allowing most of the vibration of the piezoelectric cantilever beam 600 to be output from the vibration output region. In some embodiments, one end of the piezoelectric cantilever beam 600 along a length direction may be the vibration output region, and the other end along the length direction corresponding to the vibration output region may be the fixed region.

In some embodiments, when no concave structures are provided, during the vibration process of the piezoelectric cantilever beam 600, stress is mainly distributed in the electrode 612, and the stress in the piezoelectric layer 611, which requires high stress, is relatively small. This may result in a small signal output from the piezoelectric cantilever beam 600. Therefore, to improve the stress distribution in the piezoelectric cantilever beam 600 and enhance the stress intensity in the piezoelectric layer 611, a plurality of concave structures 630 may be provided on the electrode 612 or the piezoelectric cantilever beam 600 along a thickness direction of the electrode 612 or the piezoelectric layer 611. A geometric shape of an end of the concave structure 630 where the concave structure 630 is concave in the thickness direction of the piezoelectric layer 611 may have a relatively abrupt change, causing stress concentration in the end and nearby locations, thereby increasing the stress in the piezoelectric layer 611 of the piezoelectric cantilever beam 600 and consequently enhancing the output of the piezoelectric cantilever beam 600.

In some embodiments, the concave structure 630 may include a geometric structure with an abrupt change such as a groove, an array of holes, a crack, etc. In some embodiments, as shown in FIGs. 6A-6D, the plurality of concave structures 630 may include a plurality of grooves distributed along the length direction of the piezoelectric cantilever beam 600, each of the plurality of grooves extending along a width direction of the piezoelectric cantilever beam 600. In some embodiments, a plurality of grooves may be distributed along the length direction of the piezoelectric cantilever beam 600 in the electrode 612 (e.g., the first electrode 6121 and/or the second electrode 6122 and/or the third electrode 6123) and/or the piezoelectric layer 611 (e.g., the first piezoelectric layer 6111 and/or the second piezoelectric layer 6112). In some embodiments, the plurality of grooves have groove widths along the length direction of the piezoelectric cantilever beam 600 and groove depths along the thickness direction of the piezoelectric cantilever beam 600. In some embodiments, the plurality of concave structures 630 may include an array of holes distributed along the length direction and the width direction of the piezoelectric cantilever beam 600. The array of holes may consist of a series of small holes (e.g., circular holes, square holes, etc.). The array of holes may be distributed along the length and width directions of the piezoelectric cantilever beam 600 in the electrode 612 and/or the piezoelectric layer 611.

In some embodiments, when using the concave structures 630 to improve the stress distribution in the piezoelectric cantilever beam 600, a position of the concave structures 630 in the piezoelectric cantilever beam and a structural parameter (e.g., a size, a structural shape) of the concave structures 630 may affect the effectiveness of improving the stress distribution in the piezoelectric cantilever beam 600. Below, the position of the concave structures 630 in the piezoelectric cantilever beam and the structural parameter (e.g., the size, the structural shape) of the concave structures 630 are described using an example where the concave structures 630 are distributed in the first electrode 6121 and/or the first piezoelectric layer 6111.

In some embodiments, a plurality of concave structures 630 may be distributed in a region near a fixed end of the piezoelectric cantilever beam. In some embodiments, an area of the first electrode 6121 may affect a structural capacitance of the piezoelectric cantilever beam 600, thereby influencing a signal-to-noise ratio of the piezoelectric cantilever beam 600. In some embodiments, the signal-to-noise ratio of the piezoelectric cantilever beam 600 is inversely proportional to the area of the first electrode 6121. For example, the larger the area of the first electrode 6121, the smaller a noise of the piezoelectric cantilever beam 600; the smaller the area of the first electrode 6121, the larger the noise of the piezoelectric cantilever beam 600. Therefore, the performance of the piezoelectric cantilever beam 600 may be controlled by controlling the distribution of the plurality of concave structures 630 to control the area of the first electrode 6121. In some embodiments, the plurality of concave structures 630 may be distributed in a region of the piezoelectric cantilever beam with higher stress to reduce a decrease in an overall capacitance of the piezoelectric cantilever beam 600. Based on this, the plurality of concave structures 630 may be distributed in the region near the fixed end of the piezoelectric cantilever beam 600. In some embodiments, along the length direction of the piezoelectric cantilever beam 600, the length of the region near the fixed end of the piezoelectric cantilever beam 600 may be in a range of 1/3 to 1/4 of the length of the piezoelectric cantilever beam. In other embodiments, along the length direction of the piezoelectric cantilever beam, the concave structures 630 may also be distributed throughout the entire piezoelectric cantilever beam. In some embodiments, an effective area of the first electrode 6121 may be in a range of 20% to 90% of an area of the first piezoelectric layer 6111. Preferably, the effective area of the first electrode 6121 may be in a range of 30% to 70% of the area of the first piezoelectric layer 6111. The effective area of the first electrode 6121 may be an actual area of the first electrode 6121 when the concave structures 630 are provided on the first electrode 6121.

In some embodiments, by adjusting parameters such as the size of the piezoelectric cantilever beam 600 (e.g., the thickness of the first piezoelectric layer 6111, the thickness of the first electrode 6121), the size of the concave structures 630 (e.g., the width of the concave structures 630 along the length direction of the piezoelectric cantilever beam 600, the depth of the concave structures 630 along the thickness direction of the piezoelectric cantilever beam 600), etc., the stress distribution in the piezoelectric cantilever beam 600 may be adjusted, and the stress in the first piezoelectric layer 6111 may be increased, thereby enhancing a strength of an output signal of the piezoelectric cantilever beam 600. For ease of description, the width of the concave structures 630 along the length direction of the piezoelectric cantilever beam 600 may be simply referred to as the width of the concave structures 630, the depth of the concave structures 630 along the thickness direction of the piezoelectric cantilever beam 600 may be simply referred to as the depth of the concave structures 630, and the length of the concave structures 630 along the width direction of the piezoelectric cantilever beam 600 may be simply referred to as the length of the concave structures 630.

In some embodiments, when the thickness of the first electrode 6121 is relatively small, an influence of the end and nearby positions of the end of the concave structures 630 on the stress in the first piezoelectric layer 6111 is also relatively small. Therefore, the thickness of the first electrode 6121 and the thickness of the first piezoelectric layer 6111 may be reasonably controlled to well improve the stress distribution in the piezoelectric cantilever beam 600. In some embodiments, a ratio of the thickness of the first electrode 6121 to the thickness of the first piezoelectric layer 6111 may be greater than or equal to 1:15 and less than or equal to 1:2. In some embodiments, the ratio of the thickness of the first electrode 6121 to the thickness of the first piezoelectric layer 6111 may be greater than or equal to 1:10 and less than or equal to 1:4. Merely by way of example, the thickness of the first electrode 6121 may be 200 nm, and the thickness of the first piezoelectric layer 6111 may be 1 μm. As another example, the thickness of the first electrode 6121 may be 100 nm, and the thickness of the first piezoelectric layer 6111 may be 1 μm. As yet another example, the thickness of the first electrode 6121 may be 250 nm, and the thickness of the first piezoelectric layer 6111 may be 1 μm. In some embodiments, the ratio of the thickness of the first electrode 6121 to the thickness of the first piezoelectric layer 6111 may be greater than or equal to 1:20 and less than or equal to 2:1. In some embodiments, the ratio of the thickness of the first electrode 6121 to the thickness of the first piezoelectric layer 6111 may be greater than or equal to 1.5:1 and less than or equal to 2:1.

In some embodiments, when a spacing between two adjacent concave structures of the plurality of concave structures 630, the depth of the plurality of concave structures 630, and the width of the plurality of concave structures 630 are different, a degree of stress enhancement in the first piezoelectric layer 6111 of the piezoelectric cantilever beam 600 is different. The spacing between two adjacent concave structures 630 refers to a distance between centers of the two adjacent concave structures 630. Comparing FIG. 2 and FIG. 3, in the case of a plurality of cracks, the stress intensity at the tip and its vicinity of each crack is increased compared to the case of a single crack, and the stress intensity is a summation of the stress intensity at the corresponding position of each crack, thereby along the length direction (i.e., the long axis direction) of the piezoelectric cantilever beam, a large range of stress intensity in the piezoelectric layer is increased. In some embodiments, to increase an overall stress level in the first piezoelectric layer 6111 of the piezoelectric cantilever beam 600, and to increase a range of stress concentration along the length direction (i.e., the long axis direction) of the first piezoelectric layer 6111, the spacing between two adjacent concave structures 630 may be adjusted to make stress concentration regions of the two adjacent concave structures 630 intersect, and the stress distribution in the stress concentration intersection area is the summation of the stress intensity of each concave structure 630. Since the stress concentration region at the tip of each concave structure depends on the depth of the concave structure, to effectively overlap the stress concentration regions corresponding to two adjacent concave structures, the spacing between the two adjacent concave structures 630 may be made as small as possible within a process limit. In some embodiments, the spacing between two adjacent concave structures 630 may be less than 0.5 to 5 times the depth of one concave structure of the plurality of concave structures 630. In some embodiments, the spacing between adjacent two concave structures 630 may be less than 3 times the depth of one concave structure of the plurality of concave structures 630. In some embodiments, to increase the degree of stress enhancement in the first piezoelectric layer 6111 of the piezoelectric cantilever beam 600, the width of at least one concave structure 630 among the plurality of concave structures 630 may be in the range of 0.5 to 5 times the depth of one concave structure of the plurality of concave structures 630. In some embodiments, the width of at least one concave structure 630 among a plurality of concave structures 630 may be in the range of 1 to 2 times the depth of one concave structure of the plurality of concave structures 630.

In some embodiments, the width of each concave structure of the plurality of concave structures 630 along the length direction of the piezoelectric cantilever beam 600 may be equal. In some embodiments, the width of at least some concave structures of the plurality of concave structures 630 along the length direction of the piezoelectric cantilever beam 600 may be unequal. For example, a magnitude of the stress may vary in different regions of the piezoelectric cantilever beam 600 (e.g., a region near the fixed end, a region near a free end, and an intermediate region excluding the above two regions). In some embodiments, to reduce a risk of fracture in a region with higher stress due to excessive stress, the width of the concave structures 630 in the region with higher stress (e.g., the region near the fixed end) may be greater than the width of the concave structures 630 in a region with lower stress (e.g., the region near the free end or the intermediate region). In some embodiments, to further improve an output efficiency of the piezoelectric cantilever beam 600, the stress in the region with higher stress (e.g., near the fixed end) may be further increased. For example, in the region with higher stress (e.g., the region near the fixed end), the width of the concave structures 630 may be less than the width of the concave structures 630 in the region with lower stress (e.g., the region near the free end or the intermediate region).

In some embodiments, the plurality of concave structures 630 may be evenly spaced. For example, the spacing between adjacent concave structures 630 is the same among the plurality of concave structures 630. In some embodiments, the plurality of concave structures 630 may be unevenly distributed. For example, the spacing between adjacent concave structures 630 may be the same or different. For example, the stress magnitude varies in different regions of the piezoelectric cantilever beam 600 (e.g., the region near the fixed end, the region near a free end, and the intermediate region excluding the above two regions). In some embodiments, to reduce the risk of fracture in the region with higher stress due to excessive stress, the spacing between the concave structures 630 in the region with higher stress may be greater than the spacing between the concave structures 630 in the region with lower stress. Optionally, in the region with high stress (e.g., the region near the fixed end), the plurality of concave structures 630 may be unevenly distributed; in the region with low stress (e.g., the region near the free end or the intermediate region), the plurality of concave structures 630 may be evenly spaced. In some embodiments, to further improve the output efficiency of the piezoelectric cantilever beam 600, the stress in the region with higher stress (e.g., the region near the fixed end) may be further increased. For example, the spacing between the concave structures 630 in the region with higher stress may be less than the spacing between the concave structures 630 in the region with lower stress. Optionally, in the region with higher stress (e.g., the region near the fixed end), a plurality of concave structures 630 may be evenly spaced; in the region with lower stress (e.g., the region near the free end or the intermediate region), the plurality of concave structures 630 may be unevenly distributed.

In some embodiments, the depth of at least one concave structure of the plurality of concave structures 630 may be less than or equal to the thickness of the first electrode 6121. In some embodiments, the plurality of concave structures 630 may be provided on the first electrode 6121, which are recessed in the thickness direction of the first piezoelectric layer 6111, and the plurality of concave structures 630 do not extend into the first piezoelectric layer 6111. In this case, along the thickness direction of the piezoelectric cantilever beam 600, the depth of the plurality of concave structures 630 is less than or equal to the thickness of the first electrode 6121. In some embodiments, the depth of at least one concave structure of the plurality of concave structures 630 may be greater than the thickness of the first electrode 6121. In some embodiments, the plurality of concave structures 630 may be provided on the first electrode 6121, which are recessed in the thickness direction of the first piezoelectric layer 6111, and recessions of the plurality of concave structures 630 extend into the first piezoelectric layer 6111, i.e., the plurality of concave structures 630 are located in both the first electrode 6121 and the first piezoelectric layer 6111. In this case, along the thickness direction of the piezoelectric cantilever beam 600, the depth of the plurality of concave structures 630 is greater than the thickness of the first electrode 6121. In some embodiments, the plurality of concave structures 630 may be located within the first piezoelectric layer 6111, and along the thickness direction of the piezoelectric cantilever beam 600, the plurality of concave structures 630 extend from one end surface of the first piezoelectric layer 6111 to another end surface of the first piezoelectric layer 6111. In some embodiments, the depth of each concave structure of the plurality of concave structures 630 may be the same. For example, the depth of each concave structure of the plurality of concave structures 630 may be the same and equal to the thickness of the first electrode 6121. As another example, the depth of each concave structure of the plurality of concave structures 630 may be the same and greater than or less than the thickness of the first electrode 6121. In some embodiments, at least some of the concave structures of the plurality of concave structures 630 may have different depths. In some embodiments, to reduce the risk of fracture in the region with higher stress due to excessive stress, in the region with higher stress (e.g., the region near the fixed end), the depth of the concave structures 630 may be less than the thickness of the first electrode 6121; in the region with lower stress (e.g., the region near the free end or the intermediate region), the depth of the concave structures 630 may be equal to or greater than the thickness of the first electrode 6121. In some embodiments, to further improve the output efficiency of the piezoelectric cantilever beam 600, the stress in the region with higher stress (e.g., the region near the fixed end) may be further increased. For example, in the region with higher stress (e.g., the region near the fixed end), the depth of the plurality of concave structures 630 may be equal to or greater than the thickness of the first electrode 6121; in the region with lower stress (e.g., the region near the free end or the intermediate region), the depth of the plurality of concave structures 630 may be less than the thickness of the first electrode 6121.

In some embodiments, considering a shape factor of the concave structure 630 and the ease of processing, a cross-sectional shape of at least one concave structure 630 of the plurality of concave structures 630 may include but is not limited to a regular and/or an irregular geometric shape such as a rectangular shape, an arc shape, a triangular shape, a pentagonal shape, or a hexagonal shape. The shape factor of the rectangular shape is relatively larger than the shape factor of shapes such as the arc shape, the triangular shape, the pentagonal shape, or the hexagonal shape, resulting in a higher stress. A cross-section of the concave structure 630 refers to a section perpendicular to the width direction of the piezoelectric cantilever beam 600. In some embodiments, the cross-sectional shapes of the plurality of concave structures 630 may be the same or different. In some embodiments, to reduce the risk of fracture in the region with higher stress (e.g., the region near the fixed end), the cross-sectional shapes of the plurality of concave structures 630 may be shapes with smaller shape factors, such as arc shapes; in the region with lower stress (e.g., the region near the free end or the intermediate region), the cross-sectional shapes of the plurality of concave structures 630 may be shapes with larger shape factors, such as rectangle shapes. In some embodiments, to further improve the output efficiency of the piezoelectric cantilever beam 600, the stress in the region with higher stress (e.g., the region near the fixed end) may be further increased. For example, in the region with higher stress (e.g., the region near the fixed end), the cross-sectional shapes of the plurality of concave structures 630 may be shapes with larger shape factors, such as rectangle shapes; in the region with lower stress (e.g., the region near the free end or the intermediate region), the cross-sectional shapes of the plurality of concave structures 630 may be shapes with smaller shape factors, such as arc shapes. In some embodiments, for ease of implementation in a manufacturing process, the cross-sectional shapes of the plurality of concave structures 630 on the piezoelectric cantilever beam 600 may be rectangle shapes with large shape factors and are also easier to achieve in the manufacturing process.

In some embodiments, along the width direction of the piezoelectric cantilever beam 600 (i.e., the length direction of the concave structure 630), a shape of the plurality of concave structures 630 may be one or more of a straight line, a polyline, an arc, etc. In some embodiments, the shape of the plurality of concave structures 630 along the width direction of the piezoelectric cantilever beam 600 (i.e., the length direction of the concave structure 630) may be the same or different. In some embodiments, to reduce the risk of fracture in the region with higher stress (e.g., the region near the fixed end), the shape of the plurality of concave structures 630 along the width direction of the piezoelectric cantilever beam 600 (i.e., the length direction of the concave structure 630) may be the curve or the polyline; in the region with lower stress (e.g., the region near the free end or the intermediate region), the shape of the plurality of concave structures 630 along the width direction of the piezoelectric cantilever beam 600 (i.e., the length direction of the concave structure 630) may be the straight line. In some embodiments, to further improve the output efficiency of the piezoelectric cantilever beam 600, the stress in the region with higher stress (e.g., the region near the fixed end) may be further increased. For example, in the region with higher stress (e.g., the region near the fixed end), the shape of the plurality of concave structures 630 along the width direction of the piezoelectric cantilever beam 600 (i.e., the length direction of the concave structure 630) may be the straight line; in the region with lower stress (e.g., the region near the free end or the intermediate region), the shape of the plurality of concave structures 630 along the width direction of the piezoelectric cantilever beam 600 (i.e., the length direction of the concave structure 630) may be the curve or the polyline. In some embodiments, to balance the stress distribution of the piezoelectric cantilever beam 600 and reduce the risk of fracture, the shape of each concave structure of the plurality of concave structures 630 along the width direction of the piezoelectric cantilever beam 600 (i.e., the length direction of the concave structure 630) may be the arc.

In some embodiments, when the plurality of concave structures 630 are distributed in the first electrode 6121, and the depth of the plurality of concave structures 630 equals the thickness of the first electrode 6121, the first electrode 6121 may be segmented into a plurality of isolated electrodes that are not connected to each other by the plurality of concave structures 630. Adjacent two isolated electrodes are separated by one concave structure 630 of the plurality of concave structures 630. Isolated electrodes that are not connected may not be used to transmit electrical signals. Therefore, to ensure the electrodes may conduct and transmit electrical signals, the isolated electrodes may be connected between each other. In some embodiments, the isolated electrodes between the plurality of concave structures 630 may be electrically connected by a conductive component. The conductive component may include a metal connecting part (e.g., metal wire) integrally formed with the isolated electrode or a metal layer covering the plurality of concave structures 630. In some embodiments, two adjacent isolated electrodes 630 in the electrode 612 with the plurality of concave structures may be electrically connected by a metal wire, where the metal wire is integrally formed with the plurality of concave structures 630, thus achieving an overall connection of the electrodes. In some embodiments, the metal wire may also be deposited, printed, etched, etc., to cover a plurality of isolated electrodes or the piezoelectric layer 611, thereby connecting the plurality of isolated electrodes. In some embodiments, two adjacent isolated electrodes in the electrode 612 with the plurality of concave structures 630 may be electrically connected by a metal layer, achieving the overall connection of the electrodes. For example, a plurality of isolated electrodes adhered to a surface (i.e., an adhesive end surface) of the piezoelectric layer 410 may have a thin metal layer deposited on the surface of the electrode 420, covering the surface of the plurality of concave structures 630 and the plurality of isolated electrodes. The connection between the isolated electrodes is achieved through the metal layer. In some embodiments, the metal layer may have strong conductivity. In some embodiments, the metal layer may have a certain toughness and/or ductility, ensuring that the metal layer has a certain strength, thereby preventing the metal layer from bending and damaging at the plurality of concave structures 630. In some embodiments, the thickness of the metal layer may be set relatively small to reduce an impact of the metal layer on stress concentration in the first electrode 6121 and the first piezoelectric layer 6111. Merely by way of example, a material of the metal layer may be titanium alloy, titanium platinum, etc.

In some embodiments, by providing the concave structure 630 on the piezoelectric cantilever 600, the stress in the first piezoelectric layer 6111 may be increased. However, the presence of the concave structure 630 may also make the piezoelectric cantilever beam 600prone to fracture. In some embodiments, to reduce a risk of structural fracture in the piezoelectric cantilever beam 600and ensure a reliability of a structure of the piezoelectric cantilever 600, one or more layers of a polymer material may be deposited on the surface of the plurality of concave structures 630. In some embodiments, the piezoelectric cantilever may include a polymer material layer covering the plurality of concave structures 630. In some embodiments, a Young's modulus of the polymer material layer may be less than a Young's modulus of the first piezoelectric layer 6111 or a Young's modulus of the first electrode 6121. In some embodiments, the polymer material layer may also cover the entire first electrode 6121. Along the thickness direction of the piezoelectric cantilever 600, a thickness of the polymer material layer may be within a range of 0.1 to 50 times the thickness of the first piezoelectric layer 6111. In some embodiments, along the thickness direction of the piezoelectric cantilever 600, the thickness of the polymer material layer may be within the range of 1 to 10 times the thickness of the first piezoelectric layer 6111. In some embodiments, a material of the polymer material layer may include, but is not limited to, polyimide (PI), polydimethylsiloxane (PDMS), and other process-compatible materials.

It should be noted that the concave structure 630 may be distributed not only in the first electrode 6121 (and the first piezoelectric layer 6111) but also in other electrodes (and other piezoelectric layers). For example, the plurality of concave structures 630 may be distributed in one or more electrodes such as the first electrode 6121, the second electrode 6122, and the third electrode 6123. Accordingly, a plurality of concave structures on the first electrode 6121 that are recessed in the thickness direction of the first piezoelectric layer 6111 may increase the stress in the first piezoelectric layer 6111; a plurality of concave structures on the second electrode 6122 that are recessed in the thickness direction of the first piezoelectric layer 6111 (and/or the second piezoelectric layer 6112) may increase the stress in the first piezoelectric layer 6111 (and/or the second piezoelectric layer 6112); and a plurality of concave structures on the third electrode 6123 that are recessed in the thickness direction of the second piezoelectric layer 6112 may increase the stress in the second piezoelectric layer 6112.

In some embodiments, by introducing the plurality of concave structures 630 on the piezoelectric cantilever 600, a position of a resonant frequency of the piezoelectric cantilever beam 600 may be adjusted. For example, the plurality of concave structures 630 may reduce a structural stiffness of the piezoelectric cantilever 600, thereby shifting the resonant frequency of the piezoelectric cantilever beam 600 forward (i.e., toward lower frequencies). Therefore, by adjusting relevant parameters (e.g., quantity, depth, width, length) of the concave structures 630, the resonant frequency of the piezoelectric cantilever beam 600 may be positioned within an ideal range. In some embodiments, to compensate for the forward shift in the resonant frequency caused by the concave structures 630, the length of the piezoelectric cantilever beam 600 may be reduced (equivalent to increasing the stiffness of the piezoelectric cantilever 600), causing the resonant frequency of the piezoelectric cantilever beam 600 to shift backward. Thus, while keeping the resonant frequency of the piezoelectric cantilever beam 600 unchanged, reducing the size of the piezoelectric

cantilever beam 600 by setting concave structures is beneficial for compact device design. In some embodiments, due to the presence of the concave structures 630 in the electrode 612, the sensitivity of the piezoelectric cantilever beam 600 is enhanced, thereby improving the signal-to-noise ratio of the piezoelectric cantilever beam 600 as a whole.

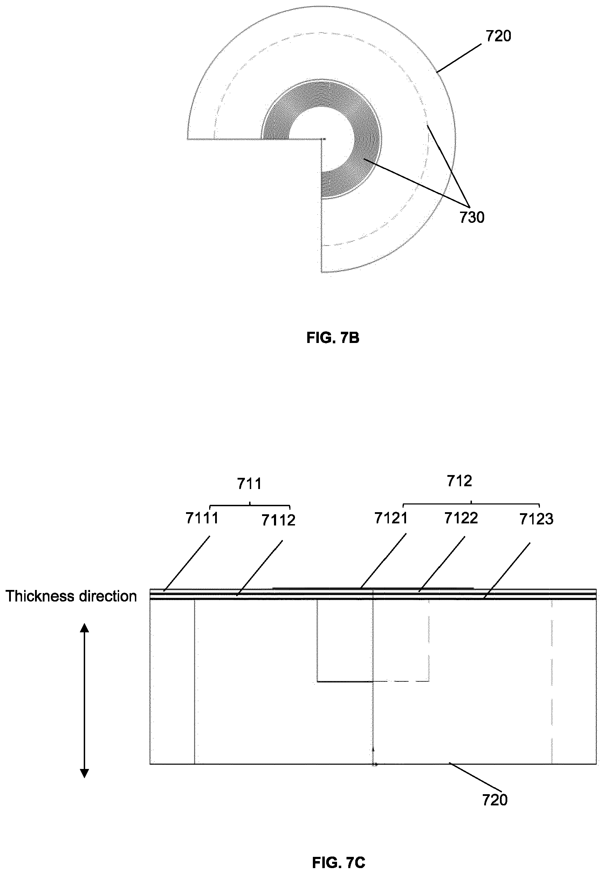

In some embodiments, the piezoelectric transducer 400 may include a piezoelectric plate or a piezoelectric film. In some embodiments, the piezoelectric plate may have a plate-like structure, while the piezoelectric film may have a film-like structure. A projected shape of the piezoelectric plate or piezoelectric film perpendicular to a thickness direction of the piezoelectric plate or piezoelectric film may include a regular and/or an irregular geometric shape such as circular, quadrilateral, pentagonal, etc. FIG. 7A is an exemplary structural diagram of a piezoelectric film according to some embodiments of the present disclosure. FIG. 7B is a top view of a piezoelectric film according to some embodiments of the present disclosure. FIG. 7C is a main view of a piezoelectric film according to some embodiments of the present disclosure.

Referring to FIGs. 7A-7C, a piezoelectric film 700 may include a piezoelectric layer 711 and an electrode 712. The electrode 712 is attached to at least one surface of the piezoelectric layer 711. In some embodiments, the piezoelectric layer 711 may include a first piezoelectric layer 7111 and a second piezoelectric layer 7112 sequentially arranged in the thickness direction of the piezoelectric film 700. The electrode 712 includes a first electrode 7121, a second electrode 7122, and a third electrode 7123 sequentially arranged in the thickness direction of the piezoelectric film 700. Along the thickness direction of the piezoelectric film 700, two piezoelectric layers and three electrode layers are alternately arranged. In other words, along the thickness direction of the piezoelectric film 700, the first electrode 7121, the first piezoelectric layer 7111, the second electrode 7122, the second piezoelectric layer 7112, and the third electrode 7123 are sequentially arranged. In some embodiments, the electrode 712 may not include the third electrode 7123, and an elastic layer may be provided at a position of the third electrode 7123, serving as part of a vibrating component 720. It may be understood that the count of the piezoelectric layers 711 and the electrodes 712 is only exemplary and does not limit the content of the present disclosure. In some embodiments, the count of the piezoelectric layers 711 and the electrodes 712 may be adjusted according to requirements or application scenarios of the piezoelectric film 700. It should be noted that FIGs. 7A-7C show three-quarters of the structure of the piezoelectric film 700 for ease of illustrating a relationship between the various layers (e.g., the piezoelectric layer 711 and the electrode 712) of the piezoelectric film 700.

In some embodiments, to improve the stress distribution in the piezoelectric film 700 and enhance the stress intensity in the piezoelectric layer 711, a plurality of concave structures 730 may be provided on the electrode 712 or the piezoelectric film 700, which recessed in the thickness direction of the electrode 712 or the piezoelectric layer 711. A geometric shape of an end of the concave structure 730 where the concave structure 730 is recessed in the thickness direction of the piezoelectric layer 711 may have a relatively abrupt change, causing stress concentration in the vicinity of the end, thereby increasing the stress in the piezoelectric layer 711 of the piezoelectric film 700 and consequently enhancing an output of the piezoelectric film 700.

In some embodiments, the concave structure 730 may include a groove, an array of holes, a crack, or other geometric structures with a relatively abrupt change. In some embodiments, a plurality of concave structures 730 may include a plurality of grooves distributed along a first direction of the piezoelectric plate or the piezoelectric film. In some embodiments, the first direction may extend from a center of the piezoelectric film 700 to an edge of the piezoelectric film 700. The edge of the piezoelectric film 700 refers to a circumferential edge of the piezoelectric film 700. For example, if the piezoelectric film 700 has a circular projection shape in its thickness direction, the first direction may be a radial direction from a center of the circular projection shape to a circumferential edge of the circular projection shape. As another example, if the piezoelectric film 700 has a square cross-sectional shape in its thickness direction, the first direction may be from a center of the square towards an edge of the square. In some embodiments, the first direction may include various directions from the center of the piezoelectric film 700 towards the edge of the piezoelectric film 700. In some embodiments, the plurality of concave structures 730 may also include an array of holes distributed along the first direction and a second direction. The first direction may be from the center to the edge of the piezoelectric plate or the piezoelectric film, and the second direction may be parallel to the edge of the piezoelectric film 700. In some embodiments, the second direction may be a circumferential direction of the piezoelectric plate or the piezoelectric film. In some embodiments, the second direction may be a circumferential direction of a closed curve.

In some embodiments, when using concave structures 730 to improve the stress distribution in the piezoelectric film 700, a position of the concave structures 730 in the piezoelectric plate or the piezoelectric film, as well as a structural parameter (e.g., a size, a structural shape) of the concave structures 730, may affect an effectiveness of improving the stress distribution in the piezoelectric film 700. Below, taking the example of the concave structures 730 distributed in the first electrode 7121 and/or the first piezoelectric layer 7111, the position and the structural parameter (e.g., the size, the structural shape) of the concave structures 730 in the piezoelectric plate or piezoelectric film is described.

In some embodiments, the plurality of concave structures 730 may be distributed within a sub-region of the piezoelectric film 700. The sub-region of the piezoelectric film 700 may include at least a portion of the piezoelectric film 700 with the same shape as the piezoelectric film 700 and centered on the center of the piezoelectric film 700. In some embodiments, the sub-region of the piezoelectric film 700 may be a region enclosed by midpoints of distances between the center of the piezoelectric film 700 and the edge of the piezoelectric film 700. For example, in the case of a circular piezoelectric film 700, the sub-region of the piezoelectric film 700 may be a circular region centered on the center of the circular piezoelectric film and with a radius equal to half of a radius of the circular piezoelectric film. In some embodiments, the plurality of concave structures 730 may be distributed at positions of higher stress in the piezoelectric film 700 to increase an output electrical signal or output mechanical quantity. For example, the plurality of concave structures 730 may be distributed outside the sub-region of the piezoelectric film 700 and inside the edge of the piezoelectric film 700, near a fixed end. By setting the distribution positions of the plurality of concave structures 730 in the piezoelectric film 700 (e.g., outside the sub-region of the piezoelectric film 700 and inside the edge of the piezoelectric film 700), on the one hand, the stress distribution in the piezoelectric film 700 can be improve, enhancing the output electrical signal or output mechanical quantity in the piezoelectric layer 711 (e.g., the first piezoelectric layer 7111); on the other hand, the sensitivity of the piezoelectric film 700 can be increase, thereby improving the signal-to-noise ratio.

In some embodiments, an area of the first electrode 7121 may affect a magnitude of a structural capacitance of the piezoelectric film 700, thereby affecting a noise and the signal-to-noise ratio of the piezoelectric film 700. In some embodiments, the noise of the piezoelectric film 700 is inversely proportional to the area of the first electrode 7121. The larger the area of the first electrode 7121, the smaller the noise of the piezoelectric film 700; the smaller the area of the first electrode 7121, the larger the noise of the piezoelectric film 700. In some embodiments, an effective area of the first electrode 7121 may be in a range of 20% to 90% of the area of the first piezoelectric layer 7111. In some embodiments, the effective area of the first electrode 7121 may be in a range of 30% to 70% of the area of the first piezoelectric layer 7111.

In some embodiments, by adjusting parameters such as the size of the piezoelectric film 700 (e.g., a thickness of the first piezoelectric layer 7111, a thickness of the first electrode 7121), a size of the plurality of concave structures 730 (e.g., a width of the plurality of concave structures 730 along the first direction of the piezoelectric film 700, a depth of the plurality of concave structures 730 along the thickness direction of the piezoelectric film 700), etc., the stress distribution in the piezoelectric film 700 may be adjusted, increasing the stress in the first piezoelectric layer 7111 and consequently enhancing the output signal strength of the piezoelectric film 700. For ease of description, the width of the plurality of concave structures 730 730 along the first direction of the piezoelectric film 700 may be simply referred to as the width of the plurality of concave structures 730, the depth of the plurality of concave structures 730 along the thickness direction of the piezoelectric film 700 may be simply referred to as the depth of the plurality of concave structures 730, and the length of the plurality of concave structures 730 along the second direction of the piezoelectric film 700 may be simply referred to as the length of the plurality of concave structures 730.

In some embodiments, when the thickness of the first electrode 7121 is relatively small, an influence of stress on the first piezoelectric layer 7111 near an end and nearby positions of the end of the concave structure 730 is also relatively small. Therefore, the thickness of the first electrode 7121 and the thickness of the first piezoelectric layer 7111 may be reasonably controlled to well improve the stress distribution in the piezoelectric film 700. In some embodiments, a ratio of the thickness of the first electrode 7121 to the thickness of the first piezoelectric layer 7111 may be greater than or equal to 1:15 and less than or equal to 1:2. In some embodiments, the ratio of the thickness of the first electrode 7121 to the thickness of the first piezoelectric layer 7111 may be greater than or equal to 1:1 and less than or equal to 1:4. For example, the thickness of the first electrode 7121 may be 200 nm, and the thickness of the first piezoelectric layer 7111 may be 1 um. As another example, the thickness of the first electrode 7121 may be 100 nm, and the thickness of the first piezoelectric layer 7111 may be 1 um. As yet another example, the thickness of the first electrode 7121 may be 250 nm, and the thickness of the first piezoelectric layer 7111 may be 1 um. In some embodiments, the ratio of the thickness of the first electrode 7121 to the thickness of the first piezoelectric layer 7111 may be greater than or equal to 1:20 and less than or equal to 2:1. In some embodiments, the ratio of the thickness of the first electrode 7121 to the thickness of the first piezoelectric layer 7111 may be greater than or equal to 1.5:1 and less than or equal to 2:1.

In some embodiments, when a spacing between two adjacent concave structures of the plurality of concave structures 730, the depths of the plurality of concave structures 730, and the widths of the plurality of concave structures 730 are different, degrees of stress enhancement in the first piezoelectric layer 7111 of the piezoelectric film 700 are different. In some embodiments, to increase an overall stress level in the first piezoelectric layer 7111 of the piezoelectric film 700 and increase the stress concentration range along the first direction of the piezoelectric film 700, the spacing between two adjacent concave structures of the plurality of concave structures 730 may be adjusted so that stress concentration regions of the two adjacent concave structures 730 intersect, and the stress distribution in the intersected region is a summation of the stress intensity of each concave structure 730. Since the stress concentration region generated at a tip of each concave structure depends on the depth of the concave structure, to effectively overlap the stress concentration regions corresponding to two adjacent concave structures, in some embodiments, the spacing between two adjacent concave structures of the plurality of concave structures 730 may be within a range of 0.5 to 5 times the depth of one concave structure of the plurality of concave structures 730. In some embodiments, the spacing between two adjacent concave structures 730 of the plurality of concave structures may be within a range of less than 3 times the depth of one concave structure of the plurality of concave structures 730. In some embodiments, to increase the degree of stress enhancement in the first piezoelectric layer 7111 of the piezoelectric film 700, the width of at least one concave structure 730 of the plurality of concave structures 730 may be within a range of 0.5 to 5 times the depth of one concave structure of the plurality of concave structures 730. In some embodiments, the width of at least one concave structure 730 of the plurality of concave structures 730 may be within a range of 1 to 2 times the depth of one concave structure of the plurality of concave structures 730.

In some embodiments, the width of each concave structure 730 of the plurality of concave structures 730 along the first direction of the piezoelectric film 700 may be equal. In some embodiments, the width of at least some concave structures 730 of the plurality of concave structures 730 along the first direction of the piezoelectric film 700 may be unequal. For example, a magnitude of the stress may vary in different regions of the piezoelectric film 700 (e.g., a region near the fixed end, a region near a free end, and an intermediate region excluding the above two regions). In some embodiments, to reduce a risk of fracture in a region with higher stress due to excessive stress, the width of the concave structures 730 in the region with higher stress (e.g., the region near the fixed end) may be greater than the width of the concave structures 730 in the region with lower stress (e.g., the intermediate region). In some embodiments, to further increase an output efficiency of the piezoelectric film 700, the stress in the region with higher stress (e.g., the region near the fixed end) may be further increased. For example, the width of the concave structures 730 in the region with higher stress (e.g., the region near the fixed end) may be less than the width of the concave structures 730 in the region with lower stress (e.g., the intermediate region).

In some embodiments, a plurality of concave structures 730 may be evenly spaced. For example, the spacing between two adjacent concave structures 730 of the plurality of concave structures 730 may be the same. In some embodiments, the plurality of concave structures 730 may be unevenly spaced. For example, the spacing between two adjacent concave structures 730 of the plurality of concave structures 730 may be the same or different. As mentioned above, the magnitude of the stress may vary in different regions (e.g., the region near the fixed end and the intermediate region near a center point) of the piezoelectric film 700. In some embodiments, to reduce the risk of fracture in a region with higher stress due to excessive stress, the spacing between concave structures in the region with higher stress may be greater than the spacing between concave structures in the region with lower stress. Optionally, the plurality of concave structures 730 in the region with higher stress (e.g., the region near the fixed end) may be unevenly spaced, while the plurality of concave structures 730 in the region with lower stress (e.g., the intermediate region) may be evenly spaced. In some embodiments, to further increase the output efficiency of the piezoelectric film 700, the spacing between concave structures in the region with higher stress may be less than the spacing between concave structures in the region with lower stress. Optionally, the stress in the region with higher stress (e.g., the region near the fixed end) may be further increased. For example, the plurality of concave structures 730 in the region with higher stress (e.g., the region near the fixed end) may be evenly spaced, while the plurality of concave structures 730 in the region with lower stress (e.g., the region near the free end or the intermediate region) may be unevenly spaced.

In some embodiments, the depth of at least one concave structure 730 of the plurality of concave structures 730 may be less than or equal to the thickness of the first electrode 7121. In some embodiments, the plurality of concave structures 730 that are recessed in the thickness direction of the first piezoelectric layer 7111 may be provided on the first electrode 7121, and the plurality of concave structures 730 do not extend into the first piezoelectric layer 7111. In this case, along the thickness direction of the piezoelectric film 700, the depth of the plurality of concave structures 730 is less than or equal to the thickness of the first electrode 7121. In some embodiments, the depth of at least one concave structure of the plurality of concave structures 730 may be greater than the thickness of the first electrode 7121. In some embodiments, the plurality of concave structures 730 that are recessed in the direction of the thickness of the first piezoelectric layer 7111 may be provided on the first electrode 7121, and recessions of the plurality of concave structures 730 extend into the first piezoelectric layer 7111, i.e., the plurality of concave structures 730 are located on both the first electrode 7121 and the first piezoelectric layer 7111. In some embodiments, the plurality of concave structures 730 may be provided in the first piezoelectric layer 7111, extending from one end surface of the first piezoelectric layer 711 to another end surface along the thickness direction of the piezoelectric film 700. In some embodiments, the depth of each concave structure 730 of the plurality of concave structures 730 may be the same. For example, the depth of each concave structure 730 of the plurality of concave structures 730 may be the same and equal to the thickness of the first electrode 7121. As another example, the depth of each concave structure 730 of the plurality of concave structures 730 may be the same and greater than the thickness of the first electrode 7121. In some embodiments, at least some concave structures 730 of the plurality of concave structures 730 may have different depths. In some embodiments, to reduce the risk of fracture in a region with higher stress due to excessive stress, the depth of the concave structures 730 in the with higher stress (e.g., the region near the fixed end) may be less than the thickness of the first electrode 7121; in a region with lower stress (e.g., the region near the intermediate region), the depth of the concave structures 730 may be equal to or greater than the thickness of the first electrode 7121. In some embodiments, to further increase the output efficiency of the piezoelectric film 700, the stress in the region with higher stress may be further increased. For example, the depth of the concave structures 730 in the region with higher stress (e.g., the region near the fixed end) may be equal to or greater than the thickness of the first electrode 7121; the depth of the concave structures 730 in the region with lower stress (e.g., the region near the free end or the intermediate region) may be less than the thickness of the first electrode 7121.

In some embodiments, considering a shape factor of the concave structure 730 and the ease of processing, a cross-sectional shape of at least one concave structure 730 of the plurality of concave structures 730 may include, but is not limited to, a regular and/or an irregular geometric shape such as a rectangular shape, an arc shape, a triangular shape, a pentagonal shape, or a hexagonal shape. The shape factor of the rectangular shape is relatively larger compared to the shape factor of shapes like the arc shape, the triangular shape, the pentagonal shape, or the hexagonal shape, resulting in higher stress correspondingly. A cross-section of the concave structure 730 refers to a section perpendicular to the second direction of the piezoelectric film 700. In some embodiments, the cross-sectional shape of the plurality of concave structures 730 may be the same or different. In some embodiments, to reduce the risk of fracture in a region with higher stress due to excessive stress, the cross-sectional shape of the plurality of concave structures 730 in the region with higher stress (e.g., the region near the fixed end) may be a shape with a smaller shape factor, such as the arc shape; the cross-sectional shape of the plurality of concave structures 730 in a region with lower stress (e.g., the region near the intermediate region) may be a shape with a larger shape factor, such as the rectangle shape. In some embodiments, to further increase the output efficiency of the piezoelectric film 700, the stress in the region with higher stress may be further increased. For example, the cross-sectional shape of the plurality of concave structures 730 in the region with higher stress (e.g., the region near the fixed end) may be a shape with a larger shape factor, such as the rectangle shape; the cross-sectional shape of the plurality of concave structures 730 in the region with lower stress (e.g., near the intermediate region) may be a shape with a smaller shape factor, such as the arc shape. In some embodiments, for easier implementation in a manufacturing process, the cross-sectional shape of the plurality of concave structures 730 on the piezoelectric film 700 may be the rectangle shape with a larger shape factor that is also easier to achieve in the manufacturing process.

In some embodiments, along the first direction of the piezoelectric film 700 (i.e., the length direction of the concave structure 730), a shape of the plurality of concave structures 730 may be one or more of a straight line, a polyline, an arc, etc. In some embodiments, the shape of the plurality of concave structures 730 along the first direction of the piezoelectric film 700 (i.e., the length direction of the concave structure 730) may be the same or different. In some embodiments, to reduce the risk of fracture in a region with higher stress due to excessive stress, the shape of the plurality of concave structures 730 along the first direction of the piezoelectric film 700 (i.e., the length direction of the concave structure 730) in the region with higher stress (e.g., the region near the fixed end) may be the curve or the polyline; the shape of the plurality of concave structures 730 along the first direction of the piezoelectric film 700 (i.e., the length direction of the concave structure 730) in a region with lower stress (e.g., the region near the intermediate region) may be the straight line. In some embodiments, to further increase the output efficiency of the piezoelectric film 700, the stress in the region with higher stress may be further increased. For example, the shape of the plurality of concave structures 730 along the first direction of the piezoelectric film 700 (i.e., the length direction of the concave structure 730) in the region with higher stress (e.g., the region near the fixed end) may be the straight line; the shape of the plurality of concave structures 730 along the first direction of the piezoelectric film 700 (i.e., the length direction of the concave structure 730) in the region with lower stress (e.g., the region near the intermediate region) may be the curve or the polyline. In some embodiments, to balance the stress distribution of the piezoelectric film 700 and reduce the risk of fracture of the piezoelectric film 700, the shape of each concave structure 730 of the plurality of concave structures 730 along the first direction of the piezoelectric film 700 (i.e., the length direction of the concave structure 730) may be the arc.

In some embodiments, when the concave structure 730 is distributed in the first electrode 7121 and the depth of the concave structure 730 is equal to the thickness of the first electrode 7121, the first electrode 7121 may be segmented into a plurality of isolated electrodes that are not connected to each other by a plurality of concave structures 730. One concave structure 730 of the plurality of concave structures 730 separates adjacent isolated electrode. Isolated electrodes that are not connected may not be used to transmit electrical signals. Therefore, to ensure that the electrodes conduct and transmit electrical signals, the plurality of isolated electrodes may be connected. In some embodiments, the isolated electrodes between the plurality of concave structures 730 may be electrically connected by a conductive component. In some embodiments, the conductive component may include a metal wire or a metal layer covering the plurality of concave structures 730. In some embodiments, two adjacent isolated electrodes in the electrode 712 with the plurality of concave structures 730 may be electrically connected by the metal wire, thereby achieving an overall connection of the electrodes. Along a distribution direction of the concave structure 730 (e.g., the first direction and/or the second direction of the piezoelectric film 700), the plurality of isolated electrodes may be serially connected by the metal wire to achieve interconnection of the first electrode 7121. In some embodiments, the metal wire may be integrally formed with the plurality of isolated electrodes or deposited, printed, etched, etc., to cover the plurality of isolated electrodes or the piezoelectric layer 711, thereby connecting the plurality of isolated electrodes. In some embodiments, two adjacent isolated electrodes in the electrode 712 with the plurality of concave structures 730 may be electrically connected by the metal layer, achieving the overall connection of the electrodes. After the plurality of isolated electrodes are adhered to a surface (i.e., an adhesive end surface) of the piezoelectric layer 711, a thin layer of metal layer may be deposited on the surface of the electrode 712, covering the surfaces of the plurality of concave structures 730 and the plurality of isolated electrodes. The connection between the plurality of isolated electrodes is achieved through the metal layer. In some embodiments, the metal layer may exhibit strong conductivity. The metal layer may also have a certain toughness and/or ductility in some embodiments, ensuring that the metal layer has a certain strength, thereby preventing the metal layer from bending and damaging at the concave structure 730. In some embodiments, a thickness of the metal layer may be set relatively small, reducing an impact of the metal layer on stress concentration in the first electrode 7121 and the first piezoelectric layer 7111. Merely by way of example, a material of the metal layer may be titanium alloy, titanium platinum, etc.

In some embodiments, by providing the concave structure 730 on the piezoelectric film 700, the stress in the first piezoelectric layer 7111 may be increased. However, the presence of the concave structure 730 may also make the piezoelectric film 700 prone to fracture. Therefore, to reduce a risk of structural fracture of the piezoelectric film 700 and ensure a reliability of the structure of the piezoelectric film 700, one or more polymer material layers may be deposited on the surface of the concave structure 730. In some embodiments, the piezoelectric film 700 may include a polymer material layer covering a plurality of concave structures 730. In some embodiments, a Young's modulus of the polymer material layer may be less than a Young's modulus of the first piezoelectric layer 7111 or a Young's modulus of the first electrode 7121. In some embodiments, the polymer material layer may cover the entire first electrode 7121. In some embodiments, a thickness of the polymer material layer along the thickness direction of the piezoelectric film 700 may be in a range of 0.1 to 50 times the thickness of the first piezoelectric layer 7111. In some embodiments, along the thickness direction of the piezoelectric film 700, the thickness of the polymer material layer may be in a range of 1 to 10 times the thickness of the first piezoelectric layer 7111. In some embodiments, a material of the polymer material layer may include, but is not limited to, polyimide (PI), polydimethylsiloxane (PDMS), and other process-compatible materials.

It should be noted that the concave structure 730 may not only be distributed in the first electrode 7121 (and the first piezoelectric layer 7111) but also in other electrodes (and piezoelectric layers), such as one or more electrodes of the first electrode 7121, the second electrode 7122, and the third electrode 7123. Accordingly, a plurality of concave structures 730 on the first electrode 7121 (and the first piezoelectric layer 7111) may increase the stress in the first piezoelectric layer 7111; a plurality of concave structures 730 on the second electrode 7122 may increase the stress in the first piezoelectric layer 7111 (and/or the second piezoelectric layer 7112); and a plurality of concave structures 730 on the third electrode 7123 may increase the stress in the second piezoelectric layer 7112.

In some embodiments, when improving the stress distribution in the piezoelectric film 700 by providing the plurality of concave structures 730, a resonant frequency of the piezoelectric film 700 may change. For example, the plurality of concave structures 730 may reduce a structural stiffness of the piezoelectric plate or a structural stiffness of the piezoelectric film, causing the resonant frequency of the piezoelectric film 700 to shift forward. At this point, the resonant frequency of the piezoelectric film 700 may be shifted backward by reducing a size of the piezoelectric plate or a size of the piezoelectric film along the first direction (equivalent to increasing the structural stiffness of the piezoelectric plate or the structural stiffness of the piezoelectric film), thereby counteracting the forward shift in resonant frequency caused by the plurality of concave structures 730. This ensures that the resonant frequency of the piezoelectric film 700 remains substantially unchanged. In some embodiments, while keeping the resonant frequency of the piezoelectric cantilever 700 unchanged, the reduction in the size of the piezoelectric plate or the size of the piezoelectric film along the first direction achieved by providing the concave structure 730 is conducive to miniaturizing the device. In some embodiments, since concave structures 730 are set in the electrode 712, the sensitivity of the piezoelectric film 700 is enhanced, thereby improving the signal-to-noise ratio of the piezoelectric film 700 overall.

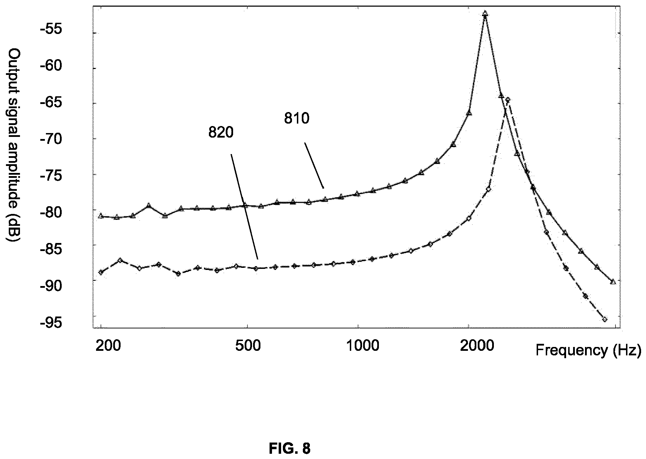

FIG. 8 is frequency response curves of piezoelectric transducers according to some embodiments of the present disclosure. The horizontal axis in FIG. 8 represents frequencies of the piezoelectric transducers in Hertz (Hz), and the vertical axis represents output signal amplitudes of the piezoelectric transducers in decibels (dB). Curve 810 represents a frequency response curve of a piezoelectric transducer with concave structures (e.g., the piezoelectric cantilever beam 600 with concave structures with a length of 750 um); curve 820 represents a frequency response curve of a piezoelectric transducer without concave structures (e.g., a 1500 um piezoelectric cantilever beam without concave structures but with other structures similar to the piezoelectric cantilever 600). In some embodiments, by providing a plurality of concave structures in an electrode or a piezoelectric layer of a piezoelectric transducer, a stress distribution in the piezoelectric transducer can be improved, thereby increasing the stress in the piezoelectric layer and enhancing an overall output of the piezoelectric transducer. For example, as shown in FIG. 8, the frequency response curve (curve 810) of the piezoelectric transducer with concave structures is shifted upward compared to the frequency response curve (curve 820) of the piezoelectric transducer without concave structures. The output of the piezoelectric transducer with concave structures is greater than the output of the piezoelectric transducer without concave structures.

In some embodiments, when a plurality of concave structures are provided on a piezoelectric transducer (e.g., the piezoelectric cantilever beam), the plurality of concave structures reduce a structural stiffness of the piezoelectric cantilever beam, causing the resonant frequency of the piezoelectric transducer to shift forward. At this point, the resonant frequency of the piezoelectric transducer may be shifted backward by reducing the length of the piezoelectric cantilever beam (equivalent to increasing the structural stiffness of the piezoelectric cantilever beam) to counteract the forward shift in resonant frequency caused by the plurality of concave structures, thereby ensuring that the resonant frequency of the piezoelectric transducer remains substantially unchanged. For example, referring to the curves 810 and 820 shown in FIG. 8, the resonant frequencies corresponding to curve 810 and curve 820 are both around 2000 Hz. In some embodiments, by reducing the length of the piezoelectric cantilever beam to keep the resonant frequency of the piezoelectric transducer unchanged, an overall size of the piezoelectric transducer may be effectively reduced. As shown in FIG. 8, while ensuring that the resonant frequencies of the piezoelectric transducers are similar, the signal amplitude at 1 kHz for the piezoelectric transducer with concave structures is approximately 10 dB higher than that for the piezoelectric transducer without concave structures. Therefore, the concave structures reduce the size of the piezoelectric transducer by 50% while increasing a signal intensity by 10 dB.

The basic concepts have been described above, and it is apparent that to a person skilled in the art, the above detailed disclosure is intended as an example only and does not constitute a limitation of the present disclosure. Although not expressly stated herein, various modifications, improvements, and amendments may be made to the present disclosure by those skilled in the art. Such modifications, improvements, and amendments are suggested in the present disclosure, so such modifications, improvements, and amendments remain within the spirit and scope of the exemplary embodiments of the present disclosure.

Also, the present disclosure uses specific words to describe the embodiments of the present disclosure. For example, "an embodiment," "one embodiment," and/or "some embodiments" are meant to refer to a certain feature, structure, or characteristic associated with at least one embodiment of the present disclosure. Accordingly, it should be emphasized and noted that "an embodiment" or "one embodiment" or "an alternative embodiment" mentioned two or more times in different places in the present disclosure do not necessarily refer to the same embodiment. Furthermore, certain features, structures, or characteristics in one or more embodiments of the present disclosure may be suitably combined.

Furthermore, those skilled in the art may understand that various aspects of the present disclosure may be explained and described through several patentable categories or situations, including any novel and useful combination of processes, machines, products, or materials, or any novel and useful improvements to them. Accordingly, various aspects of the present disclosure may be entirely executed by hardware, entirely executed by software (including firmware, resident software, microcode, etc.), or executed by a combination of hardware and software. The above hardware or software may be referred to as "blocks," "modules," "engines," "units," "components," or "systems." Additionally, various aspects of the present disclosure may manifest as computer products located on one or more computer-readable media, which include computer-readable program encoding.

Computer storage media may contain a propagation data signal that includes computer program encoding, such as on a baseband or as part of a carrier. The propagation signal may take various forms, including electromagnetic, optical, or appropriate combinations thereof. The computer storage media may be any computer-readable medium other than computer-readable storage media, which may communicate, propagate, or transmit programs for use by connecting to an instruction execution system, apparatus, or device. The program encoding on computer storage media may be propagated through any suitable medium, including radio, cable, fiber optic cable, radiofrequency (RF), or similar media, or any combination thereof.

The computer program encoding required for the operations of various parts of the present disclosure may be written in any one or more programming languages, including object-oriented programming languages such as Java, Scala, Smalltalk, Eiffel, JADE, Emerald, C++, C#, VB.NET, Python, etc., conventional procedural programming languages such as C language, Visual Basic, Fortran 2003, Perl, COBOL 2002, PHP, ABAP, dynamic programming languages such as Python, Ruby, and Groovy, or other programming languages. The program encoding may run entirely on a user's computer, run as a standalone software package on a user's computer, run partially on a user's computer and partially on a remote computer, or run entirely on a remote computer or server. In the latter case, the remote computer may be connected to the user's computer through any form of network, such as a local area network (LAN) or a wide area network (WAN), connected to external computers (e.g., through the internet), or in a cloud computing environment, or used as a service, such as software as a service (SaaS).

In addition, unless expressly stated in the claims, the order of processing elements and sequences, the use of numerical letters, or the use of other names described herein are not intended to limit the order of the processes and methods of the present disclosure. Although a number of embodiments of the present disclosure currently considered useful are discussed in the above disclosure by way of various examples, it should be understood that such details serve illustrative purposes only, and that additional claims are not limited to the disclosed embodiments; rather, the claims are intended to cover all amendments and equivalent combinations that are consistent with the substance and scope of the embodiments of the present disclosure. For example, although the implementation of various components described above may be embodied in a hardware device, it may also be implemented as a software only solution, e.g., an installation on an existing server or mobile device.

Similarly, it should be noted that in order to simplify the presentation of the present disclosure, and thus aid in the understanding of one or more embodiments of the present disclosure, the preceding description of embodiments of the present disclosure sometimes combines a plurality of features into a single embodiment, accompanying drawings, or description thereof. However, this way of disclosure does not imply that the subject matter of the present disclosure requires more features than those mentioned in the claims. Rather, claimed subject matter may lie in less than all features of a single foregoing disclosed embodiment.

In some embodiments, numeric values describing the composition and quantity of attributes are used in the description. It should be understood that such numeric values used for describing embodiments may be modified with qualifying terms such as "about," "approximately," or "generally." Unless otherwise stated, "about," "approximately," or "generally" indicates that a variation of $\pm 20\%$ is permitted in the described numbers. Accordingly, in some embodiments, the numerical parameters used in the disclosure and claims are approximations, which may change depending on the desired characteristics of the individual embodiment. In some embodiments, the numerical parameters should take into account a specified number of valid digits and employ a general manner of bit retention. Although the numerical ranges and parameters used in some embodiments of the present disclosure to confirm the breadth of the range are approximations, in specific embodiments, such numerical values are set as precisely as practicable.

With respect to each of the patents, patent applications, publications of patent applications, and other material, such as articles, books, specifications, publications, documents and the like, cited in the present disclosure, the entire contents thereof are hereby incorporated herein by reference. Application history documents that are inconsistent with the contents of the present disclosure or that create conflicts are excluded, as are documents (currently or hereafter appended to the present disclosure) that limit the broadest scope of the claims of the present disclosure. It should be noted that in the event of any inconsistency or conflict between the descriptions, definitions, and/or use of terminology in the materials appended to the present disclosure and the contents described herein, the descriptions, definitions, and/or use of terminology in the present disclosure shall prevail.

Finally, it should be understood that the embodiments described in the present disclosure are used only to illustrate the principles of the embodiments of the present disclosure. Other deformations may also fall within the scope of the present disclosure. Therefore, by way of example and not limitation, alternative configurations of the embodiments disclosed in the present disclosure may be considered consistent with the teachings of the present disclosure. Accordingly, the embodiments described in the present disclosure are not limited to the explicitly introduced and described embodiments in the present disclosure.

**Claims**

1. A piezoelectric transducer comprising:

   a piezoelectric layer; and
   an electrode, wherein the electrode overlaps at least one surface of the piezoelectric layer, and the electrode or the piezoelectric layer includes a plurality of concave structures recessed in a thickness direction of the electrode or the piezoelectric layer.

2. The piezoelectric transducer of claim 1, comprising a piezoelectric cantilever beam.

3. The piezoelectric transducer of claim 2, wherein the plurality of concave structures include a plurality of grooves distributed along a length direction of the piezoelectric cantilever beam, and each of the plurality of grooves extends in a width direction of the piezoelectric cantilever beam.

4. The piezoelectric transducer of claim 2, wherein the plurality of concave structures include an array of holes distributed along a length direction and a width direction of the piezoelectric cantilever beam.

5. The piezoelectric transducer of any one of claims 2-4, wherein the plurality of concave structures are distributed in a region near a fixed end of the piezoelectric cantilever beam.

6. The piezoelectric transducer of claim 5, wherein a length of the region near the fixed end of the piezoelectric cantilever beam is within a range of 1/3 to 1/4 of a length of the piezoelectric cantilever beam.

7. The piezoelectric transducer of claim 1, comprising a piezoelectric plate or a piezoelectric film.

8. The piezoelectric transducer of claim 7, wherein the plurality of concave structures include a plurality of grooves distributed along a first direction, where the first direction extends from a center of the piezoelectric layer to an edge of the piezoelectric layer.

9. The piezoelectric transducer of claim 7, wherein the plurality of concave structures include an array of holes distributed along a first direction and a second direction, where the first direction extends from a center of the piezoelectric layer to an edge of the piezoelectric layer, and the second direction is parallel to the edge of the piezoelectric layer.

10. The piezoelectric transducer of any one of claims 7-9, wherein the plurality of concave structures are distributed in a sub-region of the piezoelectric layer, the sub-region is a region enclosed by midpoints of distances between a center and an edge of the piezoelectric layer.

11. The piezoelectric transducer of any one of claims 7-9, wherein the plurality of concave structures are distributed outside a sub-region of the piezoelectric layer and within the edge of the piezoelectric layer, where the sub-region is a region enclosed by midpoints of distances between a center and an edge of the piezoelectric layer.

12. The piezoelectric transducer of any one of claims 1-11, wherein an effective area of the electrode is within a range of 30% to 70% of an area of the piezoelectric layer.

13. The piezoelectric transducer of any one of claims 1-12, wherein a depth of at least one concave structure of the plurality of concave structures is less than or equal to a thickness of the electrode.

14. The piezoelectric transducer of any one of claims 1-13, wherein a spacing between two adjacent concave structures of the plurality of concave structures is less than three times a depth of one concave structure of the two adjacent concave structures.

15. The piezoelectric transducer of any one of claims 1-14, wherein a width of at least one concave structure of the plurality of concave structures is equal to 1 to 2 times a depth of one concave structure of the plurality of concave structures.

16. The piezoelectric transducer of any one of claims 1-15, wherein a cross-sectional shape of at least one concave structure of the plurality of concave structures includes at least one of a rectangular shape, an arc shape, a triangular shape, a pentagonal shape, or a hexagonal shape.

17. The piezoelectric transducer of any one of claims 1-16, wherein at least one concave structure of the plurality of concave structures is arc-shaped along a length direction of the at least one concave structure.

18. The piezoelectric transducer of any one of claims 1-17, wherein a ratio of a thickness of the electrode to a thickness of the piezoelectric layer is greater than or equal to 1:10 and less than or equal to 1:4.

19. The piezoelectric transducer of any one of claims 1-18, wherein the plurality of concave structures are interconnected through a conductive component.

20. The piezoelectric transducer of claim 19, wherein the conductive component includes a metal connecting part integrally formed with the plurality of concave structures or a metal layer covering the plurality of concave structures.

21. The piezoelectric transducer of any one of claims 1-20, further comprising a polymer material layer covering the plurality of concave structures.

22. The piezoelectric transducer of claim 21, wherein a Young's modulus of the polymer material layer is less than a Young's modulus of the piezoelectric layer or a Young's modulus of the electrode.

23. The piezoelectric transducer of claim 21 or claim 22, wherein a thickness of the polymer material layer is equal to 1 to 10 times a thickness of the piezoelectric layer.

24. The piezoelectric transducer of any one of claims 1-23, wherein the plurality of concave structures are distributed on the electrode and the piezoelectric layer, and recessions of the plurality of concave structures extend from the electrode to the piezoelectric layer.

25. An acoustic output device comprising a piezoelectric transducer of any one of claims 1-24.

26. A sound transmission device comprising a piezoelectric transducer of any one of claims 1-24.

FIG. 1

FIG. 2

FIG. 3

**400**

Piezoelectric layer  410

Electrode 420

**FIG. 4**

**400**

430                    420

510

410

520

Thickness
direction

FIG. 5

**600**

630

620

6121    6122    6123

612

6111    6112

611

Thickness direction

Width direction

Length direction

**FIG. 6A**

600

Length direction ↔

Width direction ↓

630

620

**FIG. 6B**

600

630

6121
6122
6123

612

6112
6111

611

620

Length direction ↔

Thickness direction ↓

**FIG. 6C**

600

612 630 611
6123 6122 6121 6111 6112

Thickness direction

**FIG. 6D**

700

730

Thickness direction

712 711 720

**FIG. 7A**

**FIG. 7B**

**FIG. 7C**

Thickness direction

**FIG. 8**

## INTERNATIONAL SEARCH REPORT

| International application No. |
| --- |
| **PCT/CN2022/093975** |

**A. CLASSIFICATION OF SUBJECT MATTER**

H02N 2/18(2006.01)i

According to International Patent Classification (IPC) or to both national classification and IPC

**B. FIELDS SEARCHED**

Minimum documentation searched (classification system followed by classification symbols)

H02N2 H04R17 H01L41

Documentation searched other than minimum documentation to the extent that such documents are included in the fields searched

Electronic data base consulted during the international search (name of data base and, where practicable, search terms used)

CNABS, CNTXT, CNKI, 百度学术, BAIDU SCHOLAR: 压电, 凹, 孔, 裂缝, 应力集中; VEN, USTXT, WOTXT, EPTXT: piezoelectric, concave, hole, crack, stress concentration

**C. DOCUMENTS CONSIDERED TO BE RELEVANT**

| Category* | Citation of document, with indication, where appropriate, of the relevant passages | Relevant to claim No. |
| --- | --- | --- |
| X | CN 112865604 A (STATE GRID XINJIANG ELECTRIC POWER CO., LTD., INFORMATION COMMUNICATION COMPANY et al.) 28 May 2021 (2021-05-28) description, paragraphs 19-21, and figures 1-5 | 1-24 |
| Y | CN 112865604 A (STATE GRID XINJIANG ELECTRIC POWER CO., LTD., INFORMATION COMMUNICATION COMPANY et al.) 28 May 2021 (2021-05-28) description, paragraphs 19-21, and figures 1-5 | 25-26 |
| X | JP 2006229901 A (DENSO CORP.) 31 August 2006 (2006-08-31) description, paragraphs 49-62, and figures 3a-3e and 4a-4f | 1-24 |
| Y | JP 2006229901 A (DENSO CORP.) 31 August 2006 (2006-08-31) description, paragraphs 49-62, and figures 3a-3e and 4a-4f | 25-26 |
| Y | JP 4249778 B2 (ELECTRONICS AND TELECOMMUNICATIONS RESEARCH INSTITUTE) 08 April 2009 (2009-04-08) description, paragraphs 27-58, and figures 2A-2C, 3A-3B and 4A-4B | 25-26 |

☐ Further documents are listed in the continuation of Box C.　　☑ See patent family annex.

| * | Special categories of cited documents: |
| --- | --- |
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| **25 October 2022** | **12 January 2023** |

| Name and mailing address of the ISA/CN | Authorized officer |
| --- | --- |
| **China National Intellectual Property Administration (ISA/CN)** **No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

**INTERNATIONAL SEARCH REPORT**
**Information on patent family members**

International application No.

**PCT/CN2022/093975**

| Patent document cited in search report | | | Publication date (day/month/year) | Patent family member(s) | | | Publication date (day/month/year) |
|---|---|---|---|---|---|---|---|
| CN | 112865604 | A | 28 May 2021 | None | | | |
| JP | 2006229901 | A | 31 August 2006 | FR | 2882488 | A1 | 25 August 2006 |
| | | | | DE | 102006007494 | A1 | 31 August 2006 |
| | | | | US | 2006186762 | A1 | 24 August 2006 |
| | | | | US | 7466064 | B2 | 16 December 2008 |
| | | | | JP | 4622574 | B2 | 02 February 2011 |
| | | | | FR | 2882488 | B1 | 05 June 2015 |
| JP | 4249778 | B2 | 08 April 2009 | US | 2007147650 | A1 | 28 June 2007 |
| | | | | JP | 2007159143 | A | 21 June 2007 |
| | | | | KR | 20070059941 | A | 12 June 2007 |
| | | | | KR | 100785803 | B1 | 13 December 2007 |

Form PCT/ISA/210 (patent family annex) (January 2015)